# EUROPEAN PATENT APPLICATION

(11) **EP 3 905 303 A1**
(43) Date of publication of application: **03.11.2021**
(21) Application number: 21171520.6
(22) Date of filing: 30.04.2021
(51) Int. Cl.: H01J 37/32

(54) **ETCHING APPARATUS AND ETCHING METHOD**

(30) Priority: 01.05.2020 JP 2020081108; 04.09.2020 JP 2020149019; 07.10.2020 JP 2020170061
(71) Applicant: Tokyo Electron Limited, Tokyo 107-6325 (JP)
(72) Inventor: Torii, Natsumi, Kurokawa-gun, 981-3629 (JP); Nagami, Koichi, Kurokawa-gun, 981-3629 (JP); Masuda, Noriiki, Kurokawa-gun, 981-3629 (JP); Suzuki, Takayuki, Kurokawa-gun, 981-3629 (JP)
(74) Representative: Hoffmann Eitle

(57) **Abstract**

An apparatus for etching a substrate includes a chamber, a substrate support, a radio frequency (RF) power supply, and a RF filter. The substrate support is disposed in the chamber. The substrate support has an electrode, an electrostatic chuck disposed on the electrode, and a conductive edge ring disposed to surround the substrate placed on the electrostatic chuck. The RF power supply is configured to supply RF power to generate plasma from a gas inside the chamber. The RF filter has a variable impedance. The edge ring and the RF filter are electrically directly connected through a connecting unit.

## Description

### Technical Field

The present disclosure relates to an etching apparatus and an etching method.

### Background

Japanese Patent Application Publication No. 2008-227063 discloses a plasma processing apparatus for performing plasma processing on a wafer that includes a substrate support disposed in a chamber and configured to place the wafer thereon, and an edge ring disposed to surround the wafer on the substrate support. In the plasma processing apparatus, a negative DC voltage is applied to the edge ring that is consumed by the plasma, so that sheath distortion is eliminated and ions are vertically incident on the entire surface of the wafer. As a result, in an edge region of the wafer, a tilting angle, indicating a slope of a recess formed by etching, with respect to a thickness direction of the wafer is corrected.

### Summary

A technique according to embodiments of the present disclosure is provided to appropriately control a tilting angle in an edge region of a substrate during etching.

In accordance with an aspect of the present disclosure, there is provided an apparatus for etching a substrate, including: a chamber; a substrate support disposed in the chamber, the substrate support having an electrode, an electrostatic chuck disposed on the electrode, and a conductive edge ring disposed to surround the substrate placed on the electrostatic chuck; a radio frequency (RF) power supply configured to supply RF power to generate plasma from a gas inside the chamber; and a RF filter whose impedance is variable. Further, the edge ring and the RF filter are electrically directly connected through a connecting unit.

### Brief Description of the Drawings

The objects and features of the present disclosure will become apparent from the following description of embodiments, given in conjunction with the accompanying drawings, in which:
FIG. 1 is a vertical cross-sectional view schematically showing a configuration of an etching apparatus according to an embodiment;
Fig. 2 shows a power supply system of the etching apparatus according to the embodiment;
FIGS. 3A and 3B respectively show a change in a shape of a sheath due to consumption of an edge ring and a slope of an incident direction of ions;
FIGS. 4A and 4B respectively show a change in a shape of a sheath and a slope of an incident direction of ions;
FIG. 5 shows a relationship between a DC voltage from a DC power supply, an impedance of a second RF filter, and a tilt correction angle;
FIG. 6 shows a method of controlling a tilting angle;
FIG. 7 shows a method of controlling a tilting angle;
FIG. 8 shows a method of controlling a tilting angle;
FIG. 9 shows a method of controlling a tilting angle;
FIG. 10 is a vertical cross-sectional view showing an example of a configuration of a connecting unit according to another embodiment;
Fig. 11A is a vertical cross-sectional view showing an example of the configuration of the connecting unit;
Fig. 11B is a vertical cross-sectional view showing an example of the configuration of the connecting unit;
Fig. 11C is a vertical cross-sectional view showing an example of the configuration of the connecting unit;
Fig. 11D is a vertical cross-sectional view showing an example of the configuration of the connecting unit;
Fig. 11E is a vertical cross-sectional view showing an example of the configuration of the connecting unit;
Fig. 11F is a vertical cross-sectional view showing an example of the configuration of the connecting unit;
FIG. 12A is a plan view showing an example of the configuration of the connecting unit;
FIG. 12B is a plan view showing an example of the configuration of the connecting unit;
FIG. 12C is a plan view showing an example of the configuration of the connecting unit;
FIG. 13A is a vertical cross-sectional view showing an example of the configuration of the connecting unit;
FIG. 13B is a vertical cross-sectional view showing an example of the configuration of the connecting unit;
FIG. 13C is a vertical cross-sectional view showing an example of the configuration of the connecting unit;
Fig. 13D is a vertical cross-sectional view showing an example of the configuration of the connecting unit;
FIG. 13E is a vertical cross-sectional view showing an example of the configuration of the connecting unit;
Fig. 13F is a vertical cross-sectional view showing an example of the configuration of the connecting unit;
Fig. 13G is a vertical cross-sectional view showing an example of the configuration of the connecting unit;
FIG. 14A is a schematic view showing an example of a configuration of a connecting unit and an RF filter;
FIG. 14B is a schematic view showing an example of a configuration of the connecting unit and the RF filter;
FIG. 14C is a schematic view showing an example of a configuration of the connecting unit and the RF filter;
FIG. 15 is a vertical cross-sectional view showing an example of a configuration of a supply unit and an exhaust unit according to another embodiment;
FIG. 16 shows an example of a flow of a temporary adsorption sequence;
FIG. 17 shows an example of a flow of a main adsorption sequence;
FIG. 18 shows a power supply system of an etching apparatus according to another embodiment;
FIG. 19 shows a relationship between an impedance of the second RF filter and the tilt correction angle;
FIG. 20 is a vertical cross-sectional view showing an example of a configuration of a connecting unit according to another embodiment;
FIG. 21A is a schematic view showing an example of a configuration of a connecting unit and an RF filter according to another embodiment;
FIG. 21B is a schematic view showing an example of a configuration of a connecting unit and an RF filter according to another embodiment;
FIG. 21C is a schematic view showing an example of a configuration of a connecting unit and an RF filter according to another embodiment; and
FIG. 22 is a vertical cross-sectional view showing an example of a configuration of a supply unit and an exhaust unit according to another embodiment.

### Detailed Description

In a semiconductor device manufacturing process, a semiconductor wafer (hereinafter, referred to as "wafer") is subjected to plasma processing such as etching. In the plasma processing, plasma is generated by exciting a processing gas and the wafer is processed by the generated plasma.

The plasma processing is performed in a plasma processing apparatus. The plasma processing apparatus generally includes a chamber, a stage, and a radio frequency (RF) power supply. For example, the RF power supply includes a first RF power supply and a second RF power supply. The first RF power supply supplies a first RF power to generate plasma of a gas in the chamber. The second RF power supply supplies a second RF power for bias to a lower electrode in order to attract ions onto the wafer. The plasma is generated in an inner space of the chamber. The stage is disposed in the chamber. The stage has the lower electrode and an electrostatic chuck on the lower electrode. In one example, an edge ring is disposed on the electrostatic chuck to surround the wafer placed on the electrostatic chuck. The edge ring is provided to improve the uniformity of the plasma processing on the wafer.

As the plasma processing time is increased, the edge ring is consumed and, thus, a thickness of the edge ring is decreased. When the thickness of the edge ring is decreased, a shape of a sheath above the edge ring and an edge region of the wafer is changed. When the shape of the sheath is changed, a direction of ions incident on the edge region of the wafer is tilted with respect to a vertical direction. As a result, a recess formed in the edge region of the wafer is tilted with respect to a thickness direction of the wafer.

In order to form a recess extending in the thickness direction of the wafer in the edge region of the wafer, it is required to adjust a slope of the incident direction of ions incident on the edge region of the wafer by controlling the shape of the sheath above the edge ring and the edge region of the wafer. To this end, for example, Japanese Patent Application Publication No. 2008-227063 discloses a plasma processing apparatus configured to apply a negative DC voltage to the edge ring from a DC power supply in order to control the shape of the sheath above the edge ring and the edge region of the wafer.

However, depending on the DC voltage applied to the edge ring, there may be, for example, an electric discharge occurring between the wafer and the edge ring, so that a magnitude of the applicable DC voltage is limited. Therefore, even if an attempt is made to control an incident angle of ions by adjusting the DC voltage, the adjustment range is limited. Further, although it is desirable to reduce the frequency of replacement of the edge ring due to consumption, it may not be possible to sufficiently control the incident angle of ions simply by adjusting the DC voltage as described above. Thus, in such cases, the sufficient reduction in the frequency of replacement of the edge ring cannot be achieved.

A technique according to embodiments of the present disclosure is provided to appropriately control a tilting angle by allowing ions to be vertically incident in an edge region of a substrate during etching.

Hereinafter, an etching apparatus and an etching method according to embodiments of the present disclosure will be described with reference to the accompanying drawings. Throughout the specification and drawings, like reference numerals will be given to like parts having substantially the same function and configuration, and a redundant description thereof will be omitted.

### <Etching apparatus>

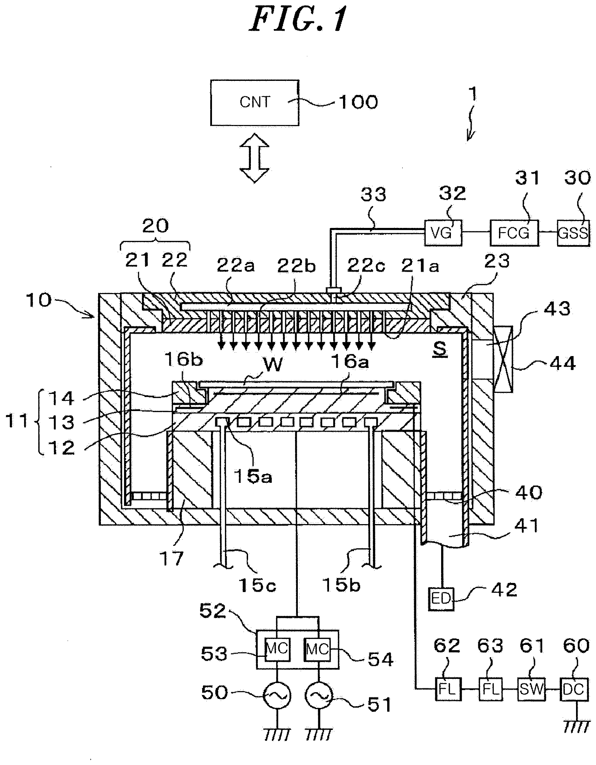

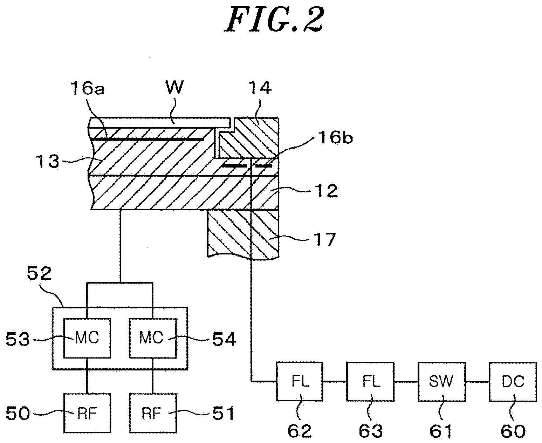

First, an etching apparatus according to an embodiment will be described. FIG. 1 is a vertical cross-sectional view schematically showing a configuration of the etching apparatus 1. FIG. 2 shows a power supply system of the etching apparatus 1. The etching apparatus 1 is a capacitively-coupled etching apparatus. The etching apparatus 1 is configured to etch the wafer W serving as a substrate.

As shown in FIG. 1, the etching apparatus 1 has a chamber 10 having a substantially cylindrical shape. The chamber 10 defines a processing space S in which plasma is generated. The chamber 10 is formed of, for example, aluminum. The chamber 10 is connected to a ground potential.

The chamber 10 includes therein a stage 11 serving as a substrate support on which the wafer W is placed. The stage 11 includes a lower electrode 12, an electrostatic chuck 13, and an edge ring 14. An electrode plate (not shown) formed of, for example, aluminum may be provided on a bottom surface of the lower electrode 12.

The lower electrode 12 is formed of a conductive material, for example, a metal such as aluminum. Further, the lower electrode 12 has a substantially disk shape.

Further, the stage 11 may include a temperature control module configured to allow at least one of the electrostatic chuck 13, the edge ring 14, and the wafer W to have a desired temperature. The temperature control module may include a heater, a flow path, or a combination thereof. A temperature control medium such as a coolant or a heat transfer gas flows through the flow path.

In one example, a flow path 15a is formed in the lower electrode 12. A temperature control medium is supplied to the flow path 15a from a chiller unit (not shown) provided outside the chamber 10 through an inlet pipe 15b. The temperature control medium supplied to the flow path 15a returns to the chiller unit through an outlet pipe 15c. By circulating the temperature control medium, for example, a coolant such as cooling water in the flow path 15a, the electrostatic chuck 13, the edge ring 14, and the wafer W can be cooled to a desired temperature.

The electrostatic chuck 13 is provided on the lower electrode 12. In one example, the electrostatic chuck 13 is a member configured to attract and hold both the wafer W and the edge ring 14 by an electrostatic force. A top surface of a central portion of the electrostatic chuck 13 is formed to be higher than a top surface of a peripheral portion of the electrostatic chuck 13. The top surface of the central portion of the electrostatic chuck 13 is a wafer support surface on which the wafer W is placed, and the top surface of the peripheral portion of the electrostatic chuck 13 is an edge ring support surface on which the edge ring 14 is placed, for example.

In one example, a first electrode 16a for attracting and holding the wafer W is provided in the central portion of the electrostatic chuck 13. A second electrode 16b for attracting and holding the edge ring 14 is provided in the peripheral portion of the electrostatic chuck 13. The electrostatic chuck 13 has a structure in which the first and second electrodes 16a and 16b are interposed between insulators made of an insulating material.

A DC voltage from a DC power supply (not shown) is applied to the first electrode 16a. Accordingly, the wafer W is attracted and held onto the top surface of the central portion of the electrostatic chuck 13 by an electrostatic force thus generated. Similarly, a DC voltage from a DC power supply (not shown) is applied to the second electrode 16b. In one example, the edge ring 14 is attracted and held on the top surface of the peripheral portion of the electrostatic chuck 13 by an electrostatic force thus generated.

In the present embodiment, the central portion of the electrostatic chuck 13 having the first electrode 16a and the peripheral portion of the electrostatic chuck 13 having the second electrode 16b are integrated with each other. However, both the first electrode 16a and the second electrode 16b may be a unipolar type electrode or a bipolar type electrode.

Further, in the present embodiment, the edge ring 14 is electrostatically attracted and held onto the electrostatic chuck 13 by applying a DC voltage to the second electrode 16b. However, the method of holding the edge ring 14 is not limited thereto. For example, the edge ring 14 may be adsorbed and held using an adsorption sheet, or the edge ring 14 may be held by clamping. Alternatively, the edge ring 14 may be held by its own weight.

The edge ring 14 is an annular member disposed to surround the wafer W placed on the top surface of the central portion of the electrostatic chuck 13. The edge ring 14 is provided to improve the etching uniformity. Therefore, the edge ring 14 is formed of a material appropriately selected according to the etching. In one example, the edge ring 14 is formed of a conductive material. Specifically, the edge ring may be made of Si or SiC.

The stage 11 configured as described above is fastened to a substantially cylindrical support member 17 provided on the bottom of the chamber 10. The support member 17 is formed of an insulator such as ceramic or quartz.

A shower head 20 is provided above the stage 11 to face the stage 11. The shower head 20 includes an electrode plate 21 disposed to face the processing space S, and an electrode support 22 disposed on the electrode plate 21. The electrode plate 21 faces the lower electrode 12 and functions as an upper electrode. When a first radio frequency power supply (RF) 50 is electrically coupled to the lower electrode 12 that will be described later, the shower head 20 is connected to a ground potential. The shower head 20 is supported at an upper portion (ceiling surface) of the chamber 10 through an insulating shielding member 23.

The electrode plate 21 is provided with a plurality of gas injection holes 21a for supplying a processing gas flowing from a gas diffusion space 22a, which will be described later, to the processing space S. The electrode plate 21 is formed of, for example, a semiconductor or a low-resistance conductor with low Joule heat.

An electrode holder 22 detachably holds the electrode plate 21. The electrode holder 22 has a structure in which a plasma-resistant film is formed on a surface of a conductive material such as aluminum. The plasma-resistant film may be a film formed by anodic oxidation treatment or a ceramic film such as yttrium oxide. The gas diffusion space 22a is formed inside the electrode holder 22. A plurality of gas holes 22b communicating with the gas injection holes 21a extend downward from the gas diffusion space 22a. Further, the gas diffusion space 22a is formed with a gas inlet port 22c connected to a gas supply pipe 33 to be described later.

Further, a gas source group (GSS) 30 for supplying the processing gas into the gas diffusion space 22a is connected to the electrode holder 22 through a flow controller group (FCG) 31, a valve group (VG) 32, the gas supply pipe 33, and the gas inlet port 22c.

The gas source group 30 includes a plurality of gas sources for etching. The flow controller group 31 includes a plurality of flow controllers, and the valve group 32 includes a plurality of valves. Each of the flow controllers in the flow controller group 31 is a mass flow controller or a pressure control type flow controller. In the etching apparatus 1, processing gases are supplied from one or more gas sources selected from the gas source group 30 to the gas diffusion space 22a through the flow controller group 31, the valve group 32, the gas supply pipe 33, and the gas inlet port 22c. Then, the processing gases supplied to the gas diffusion space 22a is diffused and supplied in a shower-like manner into the processing space S through the gas holes 22b and the gas injection holes 21a.

A baffle plate 40 is provided at a bottom portion of the chamber 10 between an inner wall of the chamber 10 and the support member 17. The baffle plate 40 is formed by, for example, coating an aluminum base with ceramics such as yttrium oxide. A plurality of through holes are formed in the baffle plate 40. The processing space S communicates with an exhaust port 41 through the baffle plate 40. An exhaust device (ED) 42 such as a vacuum pump is connected to the exhaust port 41, and the exhaust device 42 is configured to reduce the pressure in the processing space S.

Further, a loading/unloading port 43 for the wafer W is provided at a sidewall of the chamber 10, and the loading/unloading port 43 is opened and closed by a gate valve 44.

As shown in FIGS. 1 and 2, the etching apparatus 1 further includes the first radio frequency (RF) power supply 50, a second RF power supply (RF) 51, and a matching device 52. The first RF power supply 50 and the second RF power supply 51 are electrically coupled to the lower electrode 12 through the matching device 52.

The first RF power supply 50 generates RF power for plasma generation. The RF power HF having a frequency ranging from 27 MHz to 100 MHz, e.g., 40 MHz is supplied to the lower electrode 12 from the first RF power supply 50. The first RF power supply 50 is electrically coupled to the lower electrode 12 through a first matching circuit (MC) 53 of the matching device 52. The first matching circuit 53 matches an output impedance of the first RF power supply 50 with an input impedance of a load (the lower electrode 12). The first RF power supply 50 may be electrically coupled to the shower head 20 serving as the upper electrode, in place of the lower electrode 12, through the first matching circuit 53.

The second RF power supply 51 generates RF power (RF bias power) LF for drawing ions into the wafer W and supplies the RF power LF to the lower electrode 12. The RF power LF has a frequency ranging from 400 kHz to 13.56 MHz, e.g., 400 kHz. The second RF power supply 51 is electrically coupled to the lower electrode 12 through a second matching circuit (MC) 54 of the matching device 52. The second matching circuit 54 matches an output impedance of the second RF power supply 51 with an input impedance of a load (the lower electrode 12). A direct current (DC) pulse generator may be used in place of the second RF power supply 51. In this case, a pulse frequency may be in a range from 100 kHz to 2 MHz.

The etching apparatus 1 further includes a DC power supply (DC) 60, a switching unit (SW) 61, and a RF filter having a variable impedance. In the examples shown in FIGS. 1 and 2, the RF filter having the variable impedance may include a first RF filter (FL) 62 and a second RF filter (FL) 63. In this case, at least one of the first RF filter and the second RF filter may have a variable impedance configuration. The DC power supply 60 is electrically connected to the edge ring 14 through the switching unit 61, the second RF filter 63, and the first RF filter 62.

The DC power supply 60 generates a negative DC voltage to be applied to the edge ring 14. Further, the DC power supply 60 is a variable DC power supply and configured to adjust the amplitude of the DC voltage.

The switching unit 61 is configured to supply the DC voltage or stop the supply of the DC voltage from the DC power supply 60 to the edge ring 14. Those skilled in the art can appropriately design a circuit configuration of the switching unit 61.

Each of the first RF filter 62 and the second RF filter 63 is configured to suppress (attenuate) or cut off radio frequencies and is provided to protect the DC power supply 60. For example, the first RF filter 62 is configured to suppress or cut off the radio frequency of 40 MHz from the first RF power supply 50, and the second RF filter 63 is configured to suppress or cut off the radio frequency of 400 kHz from the second RF power supply 51.

In one example, the second RF filter 63 has a variable impedance configuration. That is, some of the elements of the second RF filter 63 are variable elements, so that the impedance is variable. The variable element may be, for example, either a coil (inductor) or a capacitor (capacitor). Further, the same function can be achieved by using any variable impedance element such as a diode without being limited to the coil and the capacitor. Those skilled in the art can appropriately design the number and position of the variable elements. Further, the element itself does not have to be variable. For example, the second RF filter may include a plurality of elements having fixed values, and the impedance may be variable by switching a combination of the plurality of elements using switching circuits. The circuit configurations of the second RF filter 63 and the first RF filter 62 can be appropriately designed by those skilled in the art.

The etching apparatus 1 further includes a measuring device (not shown) for measuring a self-bias voltage of the edge ring 14 (or a self-bias voltage of the lower electrode 12 or the wafer W). The configuration of the measuring device can be appropriately designed by those skilled in the art.

The etching apparatus 1 described above further includes a controller (CNT) 100. The controller 100 is, for example, a computer including a central processing unit (CPU), a memory, or the like, and has a program storage unit (not shown). A program for controlling the etching in the etching apparatus 1 is stored in the program storage unit. The program may be stored in a computer-readable storage medium and may be installed on the controller 100 from the storage medium.

### <Etching method>

Hereinafter, the etching performed by using the etching apparatus 1 configured as described above will be described.

First, the wafer W is loaded into the chamber 10 and the wafer W is placed on the electrostatic chuck 13. Thereafter, a DC voltage is applied to the first electrode 16a of the electrostatic chuck 13, so that the wafer W is electrostatically attracted to and held on the electrostatic chuck 13 by a Coulomb force. Further, after the wafer W is loaded, the pressure in the chamber 10 is reduced to a desired vacuum level by the exhaust device 42.

Next, the processing gas is supplied from the gas source group 30 to the processing space S through the shower head 20. Further, the RF power HF for plasma generation is supplied to the lower electrode 12 from the first RF power supply 50 to excite the processing gas, thereby generating plasma. At this time, the RF power LF for ion attraction may also be supplied from the second RF power supply 51. Then, the wafer W is etched by the action of the generated plasma.

At the time of completing the etching, first, the supply of the RF power HF from the first RF power supply 50 and the supply of the processing gas from the gas source group 30 are stopped. Further, if the RF power LF is supplied during the etching, the supply of the RF power LF is also stopped. Then, the supply of the heat transfer gas to a back surface of the wafer W is stopped and the attracting and holding of the wafer W by the electrostatic chuck 13 is stopped.

Thereafter, the wafer W is unloaded from the chamber 10, and a series of etching processes on the wafer W is completed.

Meanwhile, in the etching, plasma may be generated by using only the RF power LF from the second RF power supply 51 without using the RF power HF from the first RF power supply 50.

### <Tilting angle control method>

Next, in the above-mentioned etching, a method of controlling a tilting angle will be described. The tilting angle is a slope (angle) of a recess formed by etching in the edge region of the wafer W with respect to the thickness direction of the wafer W. The tilting angle of the recess is substantially the same as an angle of a slope of the incident direction of the ions incident on the edge region of the wafer W with respect to the vertical direction. In the following description, an inner-direction (center side) with respect to the thickness direction of the wafer W is referred to as an inner side, and an outer-direction with respect to the thickness direction of the wafer W is referred to as an outer side.

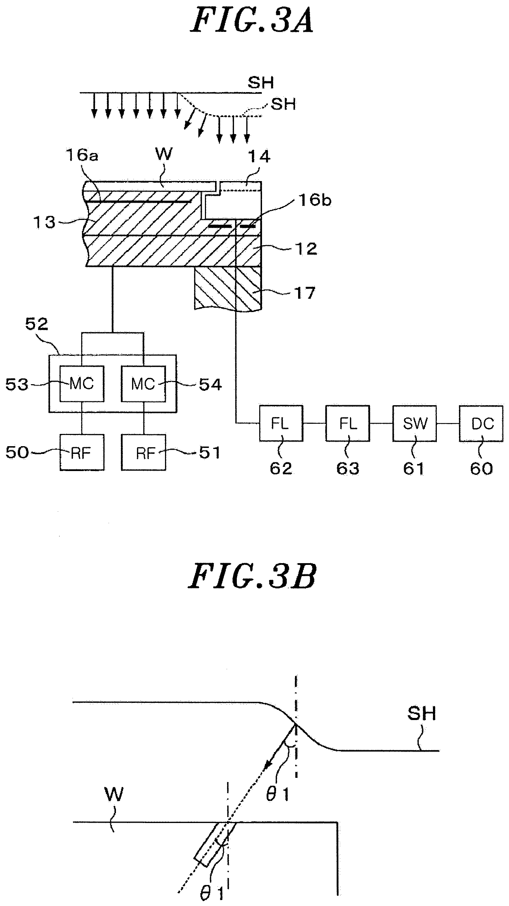

FIGS. 3A and 3B respectively show a change in the shape of the sheath due to the consumption of the edge ring and a slope of the ion incident direction. In FIG. 3A, the edge ring 14 that is not consumed is indicated by a solid line and the edge ring 14 whose thickness has been reduced due to the consumption thereof is indicated by a dotted line. Further, in FIG. 3A, the shape of the sheath SH when the edge ring 14 is not consumed is indicated by the solid line and the shape of the sheath SH when the edge ring 14 is consumed is indicated by the dotted line. Further, in FIG. 3A, an arrow indicates the ion incident direction when the edge ring 14 is consumed.

As shown in the example of FIG. 3A, when the edge ring 14 is not consumed, the flat shape of the sheath SH is maintained above the wafer W and the edge ring 14. Therefore, the ions are incident on the entire surface of the wafer W in a direction substantially perpendicular (vertical direction) to the surface of the wafer W. Therefore, the tilting angle is 0 (zero) degrees.

On the other hand, when the edge ring 14 is consumed and the thickness thereof is reduced, the thickness of the sheath SH becomes smaller above the edge region of the wafer W and the edge ring 14, thereby changing the shape of the sheath SH to a downward convex shape. As a result, the incident direction of the ions incident on the edge region of the wafer W is sloped with respect to the vertical direction. In the following description, in a case when the incident direction of the ions is sloped inward by an angle θ1 with respect to the vertical direction as shown in FIG. 3B, the recess formed by etching is sloped inward by the angle θ1 and this is referred to as an inner tilt. The cause of the inner tilt is not limited to the consumption of the edge ring 14 described above. For example, when a bias voltage generated in the edge ring 14 is lower than a voltage generated in the wafer W, the inner tilt occurs in an initial state of the edge ring 14. Further, for example, the inner tilt is intentionally induced in the initial state of the edge ring 14 and the tilting angle is corrected by the adjustment of the DC power supply 60 to be described later.

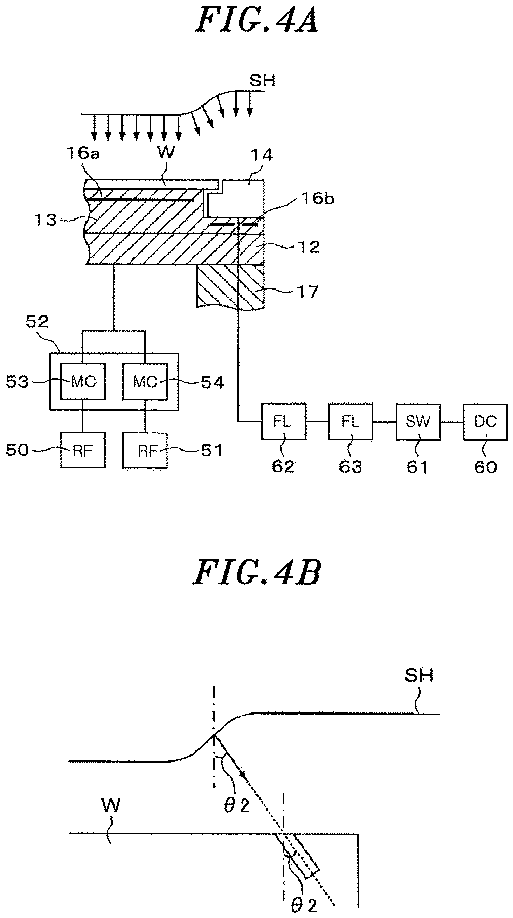

Meanwhile, as shown in FIGS. 4A and 4B, when the thickness of the sheath SH becomes larger above the edge region of the wafer W and the edge ring 14 with respect to the central region of the wafer W, the shape of the sheath SH may become an upward convex shape. For example, when the bias voltage generated in the edge ring 14 is high, the shape of the sheath SH can be the upward convex shape. In FIG. 4A, the arrow indicates the incident direction of the ion. In the following description, in a case when the incident direction of the ions is sloped outward by an angle θ2 with respect to the vertical direction as shown in FIG. 4B, the recess formed by etching is sloped outward by the angle θ2 and this is referred to as an outer tilt.

In the etching apparatus 1 of the present embodiment, the tilting angle is controlled. Specifically, the tilting angle is controlled by adjusting the DC voltage from the DC power supply 60 and the impedance of the second RF filter 63 to control the incident angle of the ions.

### <Adjustment of DC voltage>

First, the adjustment of the DC voltage applied from the DC power supply 60 will be described. In the DC power supply 60, the DC voltage applied to the edge ring 14 is set to a negative voltage having the sum of an absolute value of a self-bias voltage Vdc and a set value ΔV as an absolute value thereof, that is, "-(|Vdc| + ΔV)". The self-bias voltage Vdc is a self-bias voltage of the wafer W, and specifically a self-bias voltage of the lower electrode 12 when one or both RF powers are supplied and the DC voltage from the DC power supply 60 is not applied to the lower electrode 12. The set value ΔV is given by the controller 100.

The controller 100 sets the set value ΔV from the consumption amount of the edge ring 14 estimated from the consumption amount of the edge ring 14 (a decrease amount of the thickness of the edge ring 14 from an initial value) and the etching process conditions (e.g., processing time) based on a predetermined function or table. In other words, the controller 100 inputs the self-bias voltage and the consumption amount of the edge ring 14 to the function, or the controller 100 selects the self-bias voltage and the consumption amount of the edge ring 14 from the table to thereby determine the set value ΔV.

In order to determine the set value ΔV, the controller 100 uses, as the consumption amount of the edge ring 14, the difference between the initial thickness of the edge ring 14 and the thickness of the edge ring 14 actually measured using a measuring device such as a laser measuring device or a camera. Alternatively, the controller 100 may estimate the consumption amount of the edge ring 14 from a particular parameter by using another predetermined function or table to thereby determine the set value ΔV. This particular parameter can be any one of the self-bias voltage Vdc, a peak value Vpp of the RF power HF or the RF power LF, the load impedance, and the electrical characteristics of the edge ring 14 or around the edge ring 14. The electrical characteristics of the edge ring 14 or around the edge ring 14 can be any one of a voltage, a current, and a resistance including the edge ring 14 of the edge ring 14 or at an arbitrary position around the edge ring 14. Another function or table is predefined to determine the relationship between the particular parameter and the consumption of the edge ring 14. When the consumption amount of the edge ring 14 is estimated, the etching apparatus 1 is operated before the actual etching or during the maintenance of the etching apparatus 1 under the measurement conditions for estimating the consumption amount, that is, under the setting of the RF power HF, the RF power LF, the pressure in the processing space S, and the flow rate of the processing gas supplied to the processing space S. Then, the particular parameter is acquired, and the consumption amount of the edge ring 14 can be identified by inputting the particular parameter into another function described above or by referring to the table with the particular parameter.

In the etching apparatus 1, a DC voltage is applied from the DC power supply 60 to the edge ring 14 during the etching, that is, during a period in which one or both of the RF power HF and the RF power LF is supplied. Accordingly, the shape of the sheath above the edge ring 14 and the edge region of the wafer W is controlled and the slope of the incident direction of the ions incident on the edge region of the wafer W is reduced. Thus, the tilting angle is controlled. As a result, the recess substantially parallel to the thickness direction of the wafer W is formed over the entire region of the wafer W.

More specifically, during the etching, the self-bias voltage Vdc is measured by a measuring device (not shown). Further, a DC voltage is applied from the DC power supply 60 to the edge ring 14. The value of the DC voltage applied to the edge ring 14 is -(|Vdc| + ΔV) as described above. |Vdc| is the absolute value of the measurement value of the self-bias voltage Vdc acquired immediately before by the measuring device and ΔV is the set value determined by the controller 100. The DC voltage applied to the edge ring 14 is determined from the self-bias voltage Vdc measured during the etching. Thus, even when the self-bias voltage Vdc changes, the DC voltage generated by the DC power supply 60 is corrected and the tilting angle is appropriately corrected.

### <Impedance adjustment>

Next, the impedance adjustment of the second RF filter 63 will be described.

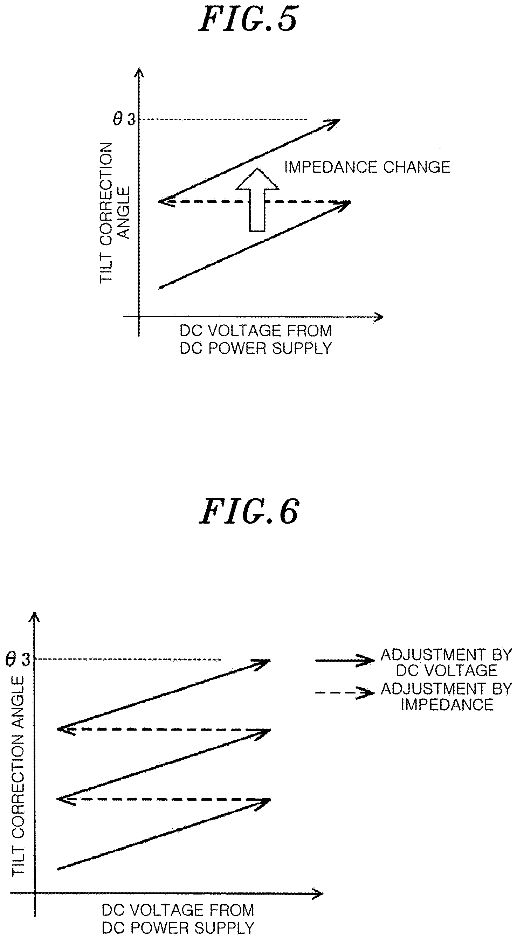

FIG. 5 shows a relationship between a DC voltage from the DC power supply 60, an impedance of the second RF filter 63, and a correction angle for a tilting angle (hereinafter referred to as "tilt correction angle"). The vertical axis of FIG. 5 indicates the tilt correction angle and the horizontal axis indicates a DC voltage from the DC power supply 60. As shown in FIG. 5, when the absolute value of the DC voltage from the DC power supply 60 is increased, the tilt correction angle becomes large. Further, adjusting the impedance of the second RF filter 63 also increases the tilt correction angle. In other words, by adjusting the impedance, the correlation between the DC voltage and the tilt correction angle can be offset to the side where the tilt correction angle becomes large.

As shown in FIGS. 3A and 3B, for example, when the edge ring 14 is consumed, the incident angle of the ions is tilted inward with respect to the vertical direction, resulting in the inner tilt. Therefore, as shown in FIG. 5, when the absolute value of the DC voltage from the DC power supply 60 is increased, the tilt correction angle becomes large and the tilting angle tilted toward the inner side is changed toward the outer side. Thus, the tilting angle can be corrected to 0 (zero) degrees. However, if the absolute value of the DC voltage is set too high, a discharge occurs between the wafer W and the edge ring 14. Since the DC voltage that can be applied to the edge ring 14 is limited, the control range is limited when the DC voltage is only adjusted to control the tilting angle.

Therefore, as shown in FIG. 5, the impedance of the second RF filter 63 is adjusted to offset the correlation between the DC voltage and the tilt correction angle to the side where the tilt correction angle becomes larger. In this case, the absolute value of the DC voltage from the DC power supply 60 can be increased again to correct the tilting angle (return to 0). Therefore, according to the present embodiment, the impedance is adjusted to increase the control range of the tilting angle without changing the adjustment range of the DC voltage.

### <Tilting angle control>

As described above, in the present embodiment, the tilting angle is controlled by adjusting the DC voltage from the DC power supply 60 and the impedance of the second RF filter 63. Hereinafter, a specific method for controlling the tilting angle will be described.

First, the edge ring 14 is placed on the electrostatic chuck 13. Then, for example, the shape of the sheath becomes a flat shape or a downward convex shape above the edge ring 14 and the edge region of the wafer W, so that the tilting angle becomes 0 (zero) degrees or the inner tilt occurs. In such a case, the adjustment range of the DC voltage can be increased when the DC voltage from the DC power supply 60 is adjusted to change the tilting angle toward the outer side, which will be described later.

Next, the etching is performed on the wafer W. As the etching time is increased, the edge ring 14 is consumed and its thickness is reduced. As a result, the thickness of the sheath SH becomes smaller above the edge region of the wafer W and the edge ring 14 and the tilting angle is changed toward the inner side.

Therefore, the DC voltage applied from the DC power supply 60 to the edge ring 14 is adjusted. Specifically, the absolute value of the DC voltage is made to increase based on the consumption amount of the edge ring 14. The consumption amount of the edge ring 14 is estimated based on the etching time of the wafer W, the number of processed wafers W, the thickness of the edge ring 14 measured by the measuring device, the changes in the electrical characteristics around the edge ring 14 (for example, voltages and currents of arbitrary points around the edge ring 14) measured by the measuring device, or the changes in the electrical characteristics of the edge ring 14 (for example, resistance value of the edge ring 14) measured by the measuring device. Further, the absolute value of the DC voltage may be made to be increased based on the etching time of the wafer W and the number of processed wafers W, regardless of the consumption amount of the edge ring 14. Further, the absolute value of the DC voltage may be made to increase based on the etching time of the wafer W weighted by the RF power (s) and the number of processed wafers W. Then, as described above, the DC voltage "is adjusted to be the sum of the absolute value of the self-bias voltage Vdc and the set value ΔV, i.e., "-(|Vdc| + ΔV)." Then, as shown in FIG. 5, the tilt correction angle becomes large and the tilting angle is changed toward the outer side, so that the tilting angle tilted toward the inner side is corrected and can be set to 0 (zero) degrees. As a result, the incident angle of the ions can be adjusted to a desired value above the edge region of the wafer W and the edge ring 14 and the tilting angle can be corrected.

Meanwhile, as the edge ring 14 is consumed, the absolute value of the DC voltage is increased. If the absolute value of the DC voltage becomes too high, a discharge may occur between the wafer W and the edge ring 14. For example, when the absolute value of the DC voltage reaches the potential difference between the wafer W and the edge ring 14, a discharge can occur.

Therefore, when the absolute value of the DC voltage reaches a predetermined value, for example, an upper limit, the impedance of the second RF filter 63 is adjusted to offset the correlation between the DC voltage and the tilt correction angle to the side where the tilt correction angle becomes larger. When the tilt correction angle is offset in the above manner, even if the edge ring 14 is further consumed, the DC voltage can be adjusted to correct the tilt angle to 0 (zero) degrees. The impedance adjustment may be performed at the time when the consumption amount of the edge ring 14 reaches a predetermined value. The consumption amount of the edge ring 14 is estimated based on the processing time of the wafer W and the thickness thereof measured by the measuring device.

At this time, the tilting angle is corrected by adjusting the DC voltage. Further, adjusting the impedance offsets the correlation between the DC voltage and the tilt correction angle. In other words, the absolute value of the DC voltage is reduced (becomes smaller) while maintaining the tilt correction angle. In such a manner, as shown in FIG. 5, the tilt correction angle can be adjusted to a target angle θ3, and the tilting angle can be set to 0 (zero) degrees. Further, as shown in FIG. 6, the adjustment of the DC voltage from the DC power supply 60 and the adjustment of the impedance of the second RF filter 63 may be repeatedly performed.

As described above, according to the present embodiment, the adjustment range of the tilting angle can be increased by adjusting the DC voltage from the DC power supply 60 and adjusting the impedance of the second RF filter 63. Therefore, the tilting angle can be appropriately controlled (that is, the incident direction of the ions can be appropriately adjusted), so that the etching can be performed uniformly.

Further, in the conventional case where the tilting angle is controlled only by adjusting the DC voltage from the DC power supply 60, it is necessary to replace the edge ring 14 when the absolute value of the DC voltage reaches the upper limit. In this respect, in the present embodiment, by adjusting the impedance of the second RF filter 63, the adjustment range of the tilting angle can be increased without replacing the edge ring 14. Therefore, the replacement interval of the edge ring 14 can be lengthened, which results in the reduction of the replacement frequency.

### <Alternative Embodiment>

In the above-described embodiment, the impedance adjustment with the second RF filter 63 is performed to offset the correlation between the DC voltage and the tilt correction angle. However, the impedance adjustment may be performed to correct the tilting angle.

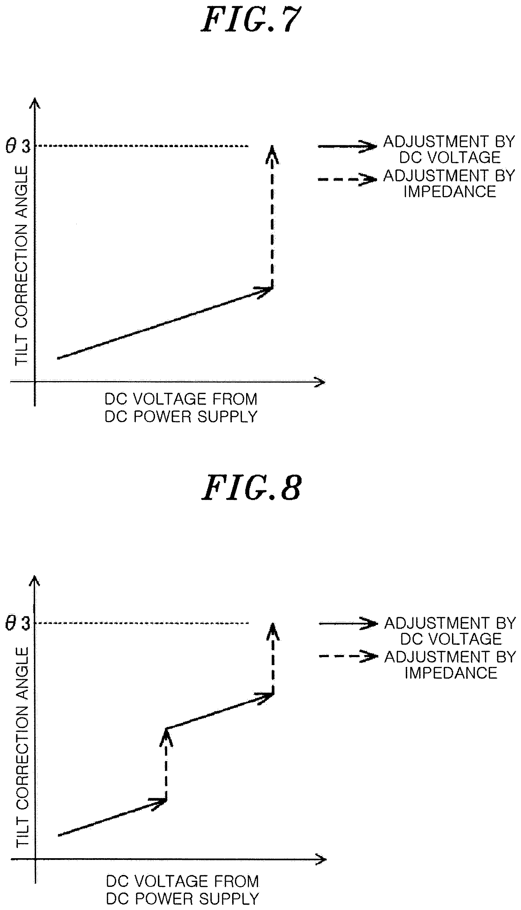

As shown in FIG. 7, first, the DC voltage from the DC power supply 60 is adjusted to correct the tilting angle. Then, when the absolute value of the DC voltage reaches a predetermined value, for example, an upper limit, the impedance of the second RF filter 63 is adjusted to adjust the tilt correction angle to a target angle θ3. Thus, the tilting angle can be set to 0 (zero) degrees. In such a case, the number of times of the DC voltage adjustment and the number of times of the impedance adjustment can be reduced, and the operation of the tilting angle control can be simplified.

Here, the resolution of the tilt angle correction by adjusting the DC voltage and the resolution of the tilt angle correction by adjusting the impedance depend on the performance of the DC power supply 60 and the second RF filter 63, respectively. The resolution of the tilt angle correction is the amount of tilt angle correction in one adjustment of DC voltage or impedance. For example, if the resolution of the second RF filter 63 is higher than the resolution of the DC power supply 60, the impedance of the second RF filter 63 is adjusted to correct the tilting angle in the present embodiment, so that the resolution of the tilt angle correction as a whole can be improved.

As described above, according to the present embodiment, it is possible to improve the resolution of the tilt angle correction while simplifying the operation of the tilting angle control. Further, the variation of the operation of the tilting angle control can be increased.

In the example shown in FIG. 7, each of the DC voltage adjustment and the impedance adjustment is performed once to adjust the tilt correction angle to the target angle θ3. However, the number of times of the DC voltage adjustment and the number of times of the impedance adjustment are not limited thereto. For example, as shown in FIG. 8, the DC voltage adjustment and the impedance adjustment may be performed multiple times. Even in such a case, the same effect as that of the present embodiment can be obtained.

### <Alternative Embodiment>

In the above-described embodiments, the impedance of the second RF filter 63 is adjusted after the DC voltage from the DC power supply 60 is adjusted. However, the reverse adjustment can be performed. That is, the DC voltage may be adjusted after the impedance is adjusted.

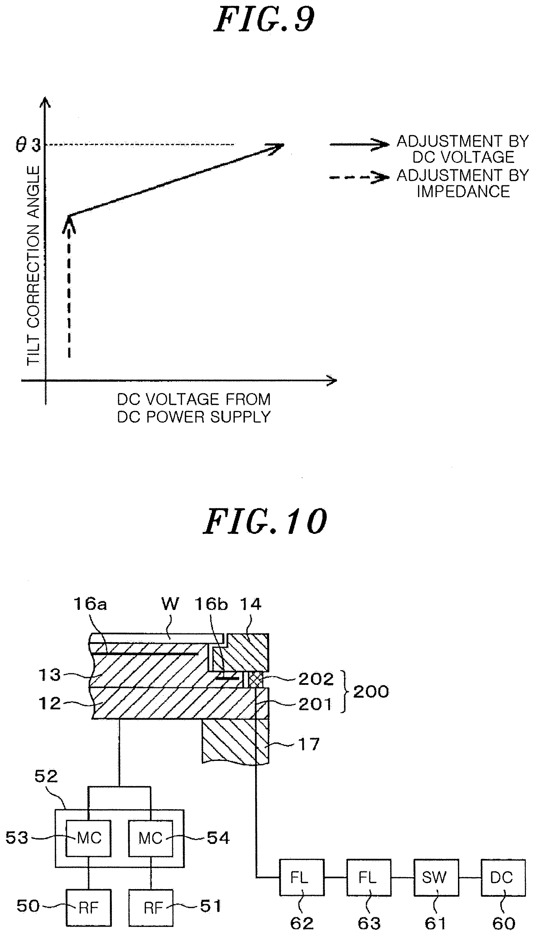

As shown in FIG. 9, first, the impedance of the second RF filter 63 is adjusted to correct the tilting angle. Then, when the impedance reaches a predetermined value, for example, an upper limit, the DC voltage from the DC power supply 60 is adjusted to adjust the tilt correction angle to the target angle θ3. Thus, the tilting angle can be set to 0 (zero) degrees.

In this embodiment as well, the same effects as those in the above-described embodiments can be obtained. That is, it is possible to improve the resolution of the tilt angle correction while simplifying the operation of the tilting angle control. The number of times of the impedance adjustment and the number of times of the DC voltage adjustment are not limited thereto and may be performed multiple times. Further, the impedance of the second RF filter 63 may be adjusted without applying the DC voltage from the DC power supply 60.

### <Alternative Embodiment>

In the above-described embodiments, the frequency of the RF power (RF bias power) LF supplied from the second RF power supply 51 is in a range from 400 kHz to 13.56 MHz. However, the frequency of 5 MHz or less is more preferred. When the wafer W is etched with a high aspect ratio during the etching, high ion energy is required to realize the vertical shape of the pattern after the etching. Therefore, as a result of studies by the present inventors, it has been found that by setting the frequency of the RF power LF to 5 MHz or less, the followability of ions to changes in the RF electric field is improved and the controllability of ion energy is improved.

When the frequency of the RF power LF is set to be a low frequency of 5 MHz or less, the effect of variable impedance of the second RF filter 63 may be reduced. That is, the controllability of the tilting angle with the impedance adjustment of the second RF filter 63 may be lowered. For example, in FIG. 2, when the electrical connection between the edge ring 14 and the second RF filter 63 is a non-contact connection or a capacitive coupling, the tilting angle cannot be appropriately adjusted even though the impedance of the second RF filter 63 is adjusted. Therefore, in the present embodiment, the edge ring 14 and the second RF filter 63 are directly electrically connected. However, as will be described later, the present embodiment may also be applied to an embodiment in which the edge ring 14 is not connected to the DC power supply 60 and the switching unit 61.

The edge ring 14 and the second RF filter 63 are directly electrically connected to each other through a connecting unit. The edge ring 14 comes into contact with the connecting unit and a direct current flows through the connecting unit. Hereinafter, an example of a structure of the connecting unit (hereinafter, may be referred to as "contact structure") will be described.

As shown in FIG. 10, the connecting unit 200 has a conductor structure 201 and a conductor member 202. The conductor structure 201 connects the edge ring 14 and the second RF filter 63 through the conductor member 202. Specifically, one end of the conductor structure 201 is connected to the second RF filter 63 and the other end is exposed on the top surface of the lower electrode 12 and is brought into contact with the conductor member 202.

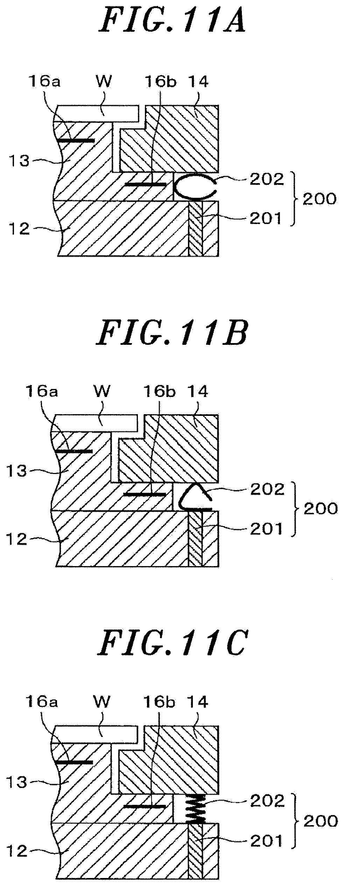

The conductor member 202 is provided, for example, in a space formed on the side of the electrostatic chuck 13 between the lower electrode 12 and the edge ring 14. The conductor member 202 is in contact with the conductor structure 201 and the bottom surface of the edge ring 14. Further, the conductor member 202 is made of, for example, a conductor such as metal. The configuration of the conductor member 202 is not particularly limited, and examples are shown in FIGS. 11A to 11F. FIGS. 11A to 11F are examples in which an elastic body is used as the conductor member 202. In FIGS. 11A to 11F, the elastic force of the conductor member 202 adjusts the contact pressure acting between the edge ring 14 and the conductor structure 201.

As shown in FIG. 11A, a coil spring that extends in the horizontal direction while being spirally wound may be used for the conductor member 202. As shown in FIG. 11B, a leaf spring pressed in the vertical direction may be used for the conductor member 202. As shown in FIG. 11C, a spring that extends in the vertical direction while being spirally wound may be used for the conductor member 202. The conductor member 202 comes into close contact with the conductor structure 201 and the bottom surface of the edge ring 14 due to the weight of the edge ring 14, so that the conductor structure 201 and the edge ring 14 are electrically connected. Further, since the conductor member 202 is an elastic body, an elastic force acts in the vertical direction. Due to this elastic force, the conductor member 202 also comes into close contact with the conductor structure 201 and the bottom surface of the edge ring 14.

As described above, the edge ring 14 is attracted and held on the top surface of the peripheral portion of the electrostatic chuck 13 by the electrostatic force generated by the second electrode 16b. In case of using the conductor member 202 shown in FIGS. 11A to 11C, even by the electrostatic force, the conductor member 202 comes into close contact with the conductor structure 201 and the bottom surface of the edge ring 14, so that the conductor structure 201 is electrically connected to the edge ring 14. In other words, the edge ring 14 is attracted and held on the peripheral portion of the electrostatic chuck 13 by the electrostatic force, and the electrostatic force adjusts the contact pressure acting between the edge ring 14 and the conductor structure 201. Therefore, by adjusting the balance between the weight of the edge ring 14, the elastic force of the conductor member 202, and the electrostatic force acting on the edge ring 14, the conductor member 202 comes into close contact with the conductor structure 201 and the bottom surface of the edge ring 14 at a desired contact pressure.

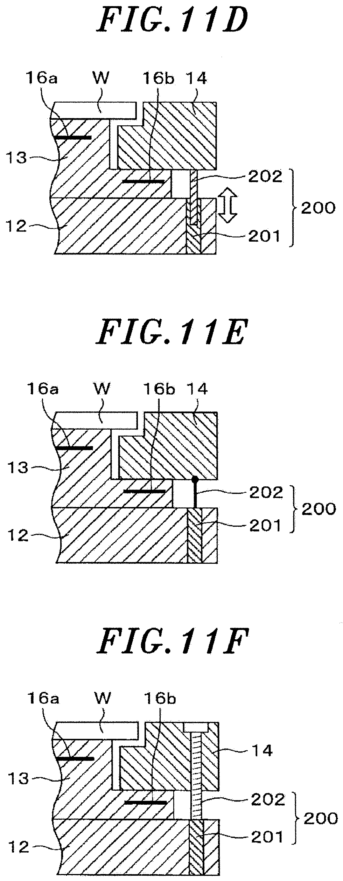

As shown in FIG. 11D, the conductor member 202 may use a pin that moves up and down by a lifting mechanism (not shown). In this case, as the conductor member 202 is moved up, the conductor member 202 comes into close contact with the conductor structure 201 and the bottom surface of the edge ring 14. Then, by adjusting the balance between the weight of the edge ring 14, the pressure acting when the conductor member 202 is vertically moved, and the electrostatic force acting on the edge ring 14, the conductor member 202 comes into close contact with the conductor structure 201 and the bottom surface of the edge ring 14 at a desired contact pressure.

As shown in FIG. 11E, a wire connecting the conductor structure 201 and the edge ring 14 may be used for the conductor member 202. One end of the wire is joined to the conductor structure 201 and the other end is joined to the bottom surface of the edge ring 14. The wire may be joined by ohmic contact with the conductor structure 201 or the bottom surface of the edge ring 14. For example, the wire is welded or crimped. As shown in FIG. 11F, a fixing screw for fixing the edge ring 14 to the electrostatic chuck 13 may be used for the conductor member 202. The fixing screw penetrates through the edge ring 14 and comes into contact with the conductor structure 201. In case of using the wire or the fixing screw for the conductor member 202 as described above, the conductor member 202 is securely in contact with the conductor structure 201 and the bottom surface of the edge ring 14, and the conductor structure 201 and the edge ring 14 are electrically connected. Further, in the above case, since the edge ring 14 is fixed to the electrostatic chuck 13 by the wire or the fixing screw, the second electrode 16b for electrostatically attracting the edge ring 14 can be omitted.

As described above, with any one of the conductor members 202 shown in FIGS. 11A to 11F, the edge ring 14 and the second RF filter 63 can be electrically directly connected to each other through the connecting unit 200 as shown in FIG 10. Therefore, the frequency of the RF power LF can be set to be a low frequency of 5 MHz or less, and the controllability of ion energy can be improved. Further, by adjusting the impedance of the second RF filter 63 as described above, the adjustment range of the tilting angle can be increased and, thus, the tilting angle can be controlled to a desired value.

In the above-described embodiments, the coil spring shown in FIG. 11A, the leaf spring shown in FIG. 11B, the spring shown in FIG. 11C, the pin shown in FIG. 11D, the wire shown in FIG. 11E, and the fixing screws shown in FIG. 11F are each used as examples of the conductor member 202, a combination thereof may be used.

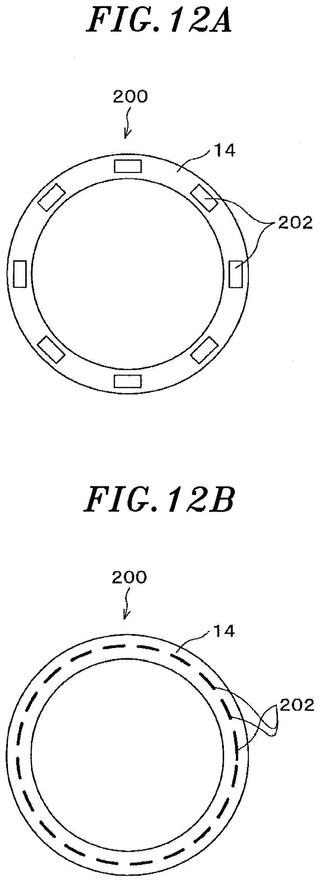

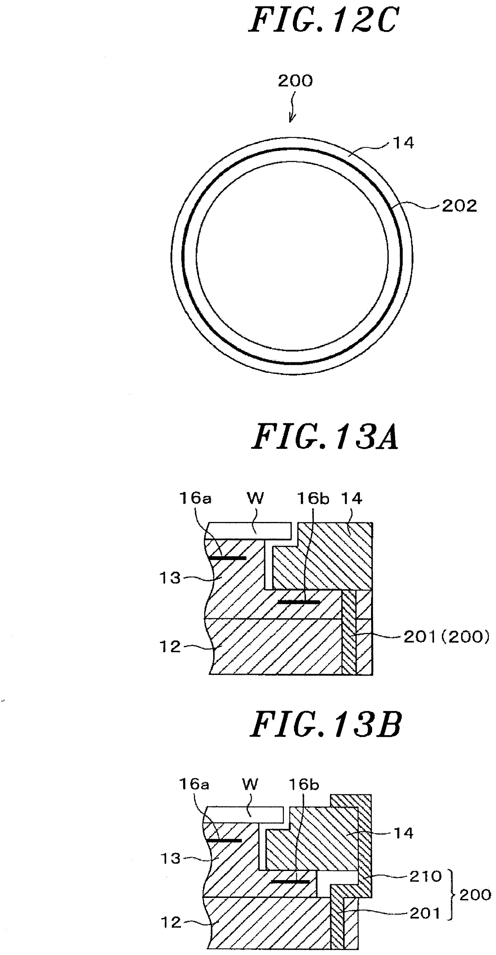

Next, the arrangement of the conductor members 202 in plan view will be described. FIGS. 12A to 12C respectively show examples of the arrangements of the conductor members 202 in plan view. As shown in FIGS. 12A and 12B, the connecting unit 200 may include a plurality of conductor members 202, and the plurality of conductor members 202 may be disposed at equal intervals on a concentric circle with the edge ring 14. In the example of FIG. 12A, the conductor members 202 are disposed at eight locations, and in the example of FIG. 12B, the conductor members 202 are disposed at 24 locations. Further, as shown in FIG. 12C, the annular conductor member 202 may be disposed concentrically with the edge ring 14.

In order to obtain the uniform shape of the sheath by performing the etching uniformly (in view of the process uniformity), it is preferable that the conductor member 202 is provided in an annular shape with respect to the edge ring 14 as shown in FIG. 12C so that the contact between the conductor member 202 and the edge ring 14 can be uniform on the circumference of the edge ring 14. Further, in view of the process uniformity, even when the plurality of conductor members 202 are provided as shown in FIGS. 12A and 12B, it is preferable that the plurality of conductor members 202 are disposed at equal intervals in the circumferential direction of the edge ring 14 and the contact points with respect to the edge ring 14 are provided point-symmetrically. In other words, it is more preferable to increase the number of conductor members 202 as in the example of FIG. 12B compared to the example of FIG. 12A so that the conductor members 202 are closer to an annular shape as shown in FIG. 12C. The number of conductor members 202 is not particularly limited. However, in order to ensure symmetry, it is preferable to have 3 or more conductor members 202, for example, 3 to 36 conductor members.

However, in order to avoid interference with other members due to the apparatus configuration, it may be difficult to provide the annular conductor member 202 or increase the number of the conductor members 202. Therefore, the arrangement of the conductor members 202 in plan view can be appropriately set in consideration of the conditions for process uniformity, the constraint conditions for the apparatus configuration, and the like.

The contact structure for contacting the edge ring 14 is not limited to the examples shown in FIGS. 10 and 11A to 11F. FIGS. 13A to 13G show other examples of the structure of the connecting unit 200.

As shown in FIG. 13A, the connecting unit 200 may not have the conductor member 202 and have only the conductor structure 201. The conductor structure 201 is in direct contact with the bottom surface of the edge ring 14. In this example, the conductor structure 201 is brought into close contact with the bottom surface of the edge ring 14 at a desired contact pressure due to the weight of the edge ring 14 and the electrostatic force applied when the edge ring 14 is attracted and held by the electrostatic chuck 13. In this case as well, the edge ring 14 and the second RF filter 63 can be directly electrically connected through the connecting unit 200 (conductor structure 201).

As shown in FIG. 13B, the connecting unit 200 may have a clamp member 210 instead of the conductor member 202 that contacts the bottom surface of the edge ring 14. The clamp member 210 comes into contact with the conductor structure 201 and the edge ring 14. Further, the clamp member 210 is made of a conductor such as metal.

The clamp member 210 has a substantially U-shape with an opening opened inward in the radial direction in the side view. The clamp member 210 comes into contact with a top surface and an outer surface of the edge ring 14 on the radially outer side of the edge ring 14 and the edge ring 14 is fitted to the clamp member 210. Then, the clamp member 210 fittedly encloses the edge ring 14 therein on the conductor structure 201 side so that the edge ring 14 is in close contact with the conductor structure 201. Thus, the edge ring 14 and the second RF filter 63 are electrically directly connected. Further, the clamp member 210 comes into close contact with the conductor structure 210 at a desired contact pressure due to the electrostatic force applied when the edge ring 14 is attracted and held by the electrostatic chuck 13, and the edge ring 14 and the second RF filter 63 are directly electrically connected.

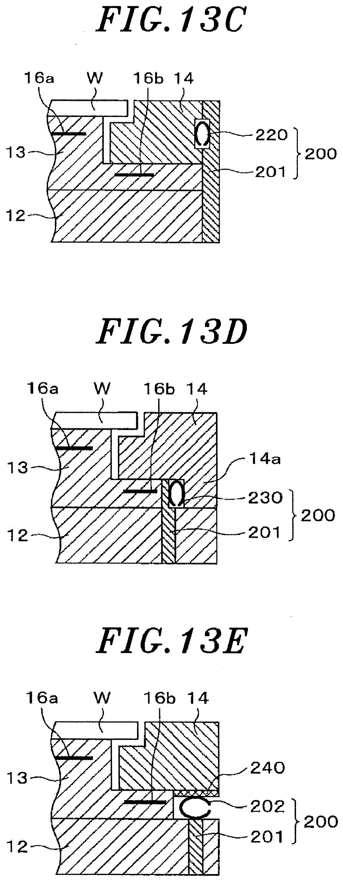

As shown in FIG. 13C, the connecting unit 200 may have a conductor member 220 that contacts the outer surface of the edge ring 14 instead of the conductor member 202 that contacts the bottom surface of the edge ring 14. In such a case, the conductor structure 201 is provided on the radially outer side of the electrostatic chuck 13 and the edge ring 14. The conductor member 220 comes into contact with the conductor structure 201 and the outer surface of the edge ring 14. In the illustrated example, the coil spring shown in FIG. 11A is used for the conductor member 220, but the leaf spring shown in FIG. 11B, the spring shown in FIG. 11C, the pin shown in FIG. 11D, the wire shown in FIG. 11E, or the fixing screw shown in FIG. 11F may be used for the conductor member 220. In any case, the conductor member 220 is in close contact with the conductor structure 201 and the outer surface of the edge ring 14 and the edge ring 14 and the second RF filter 63 are electrically directly connected.

As shown in FIG. 13D, the connecting unit 200 may have a conductor member 230 that contacts an inner surface of the edge ring 14 instead of the conductor member 202 that contacts the bottom surface of the edge ring 14. In such a case, a protruding portion 14a protruding downward is formed on the outer peripheral portion of the edge ring 14. The conductor member 230 comes into contact with the conductor structure 201 and an inner surface of the protrusion 14a of the edge ring 14. In the illustrated example, the coil spring shown in FIG. 11A is used for the conductor member 230, but the leaf spring shown in FIG. 11B, the spring shown in FIG. 11C, the pin shown in FIG. 11D, and the wire shown in FIG. 11E, or the fixing screw shown in FIG. 11F may be used for the conductor member 230. In any case, the conductor member 230 is in close contact with the conductor structure 201 and the inner surface of the edge ring 14, and the edge ring 14 and the second RF filter 63 are electrically directly connected.

Further, the arrangement of each of the clamp member 210 shown in FIG. 13B, the conductor member 220 shown in FIG. 13C, and the conductor member 230 shown in FIG. 13D in plan view may be the same as the arrangement of any one of the conductor members 202 shown in FIGS. 12A to 12C in plan view. That is, the plurality of the clamp members 210, the plurality of the conductor members 220, or the plurality of the conductor members 230 may be disposed at equal intervals on a concentric circle with the edge ring 14, or each of the clamp member 210, the conductor member 220 and the conductor member 230 may have an annular shape to be disposed concentrically with the edge ring 14.

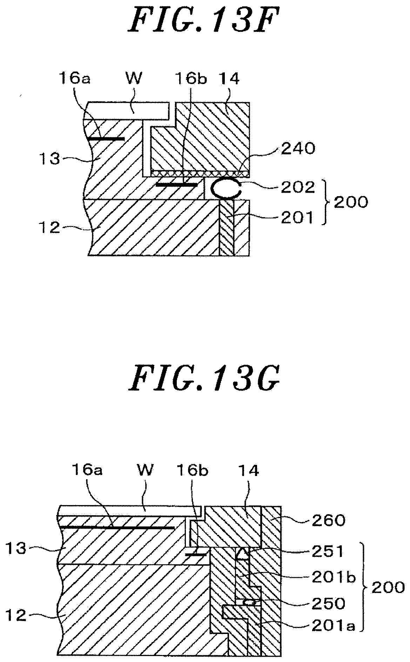

As shown in FIGS. 13E and 13F, a conductor 240 may be provided between the conductor member 202 of the connecting unit 200 and the edge ring 14. The conductor 240 is made of, for example, metal. The conductor 240 shown in FIG. 13E is brought into contact with the conductor member 202 and the bottom surface of the edge ring 14. The conductor 240 shown in FIG. 13F is formed by, for example, vapor deposition on the bottom surface of the edge ring 14 and is brought into contact with the conductor member 202. In any case, the edge ring 14 and the second RF filter 63 are electrically directly connected. The number of conductors 240 is not particularly limited. For example, a plurality of conductors 240 may be provided and the conductors 240 as a whole may have a shape close to an annular shape.

As shown in FIG. 13G, the connecting unit 200 may have conductor members 250 and 251 instead of the conductor member 202 that contacts the bottom surface of the edge ring 14. In the illustrated example, the coil spring shown in FIG. 11A is used for the conductor member 250 and the leaf spring shown in FIG. 11B is used for the conductor member 251. However, the spring shown in FIG. 11C, the pin shown in FIG. 11D, the wire shown in FIG. 11E, or the fixing screw shown in FIG. 11F may be used for each of the conductor members 250 and 251.

The conductor member 250 is disposed between a conductor structure 201a and a conductor structure 201b and comes into contact with the conductor structure 201a and the conductor structure 201b. The conductor member 251 is disposed between the conductor structure 201b and the bottom surface of the edge ring 14 and comes into contact with the conductor structure 201b and the bottom surface of the edge ring 14. An insulating member 260 is provided around the connecting unit 200 and on the radially outer side of the edge ring 14.

The arrangement of each of the conductor members 250 and 251 shown in FIG. 13G in plan view may be the same as the arrangement of any one of the conductor members 202 shown in FIGS. 12A to 12C in plan view. That is, the conductor members 250 or the conductor members 251 may be disposed at equal intervals on a concentric circle with the edge ring 14, or each of the conductor members 250 and 251 may have an annular shape to be disposed concentrically with the edge ring 14.

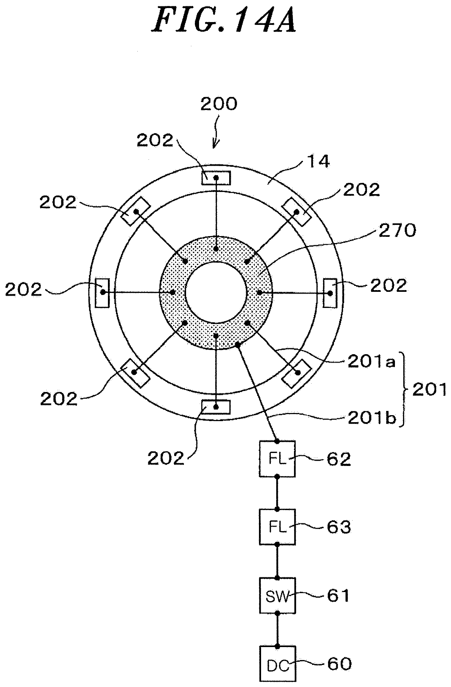

Next, the relationship between the connecting unit 200, the first RF filter 62, and the second RF filter 63 will be described. FIGS. 14A to 14C each schematically show an example of the configuration of the connecting unit 200, the first RF filter 62, and the second RF filter 63.

As shown in FIG. 14A, for example, when one first RF filter 62 and one second RF filter 63 are provided for eight conductor members 202, the connecting unit 200 further may include a relay member 270. Although FIG. 14A shows the case where the relay member 270 is provided in the connecting unit 200 shown in FIG. 12A, the relay member 270 may be provided in the connecting unit 200 shown in either FIG. 12B or FIG. 12C. Further, a plurality of relay members 270 may be provided.

The relay member 270 has an annular shape and is disposed concentrically with the edge ring 14 in the conductor structure 201 between the conductor members 202 and the second RF filter 63. The relay member 270 is connected to the conductor member 202 through conductor structures 201a. Specifically, eight conductor structures 201a extend radially from the relay member 270 in a plan view and are connected to the eight conductor members 202, respectively. Further, the relay member 270 is connected to the second RF filter 63 through the first RF filter 62 by the conductor structure 201b.

In this case, for example, even when the second RF filter 63 is not arranged at the center of the edge ring 14, the electrical characteristics (arbitrary voltage and current) of the relay member 270 can be controlled to be uniform on the circumference of the relay member 270, and the electrical characteristics for the eight conductor members 202 can also be controlled to be uniform. As a result, the etching can be performed uniformly and the uniformity of the sheath shape can be obtained.

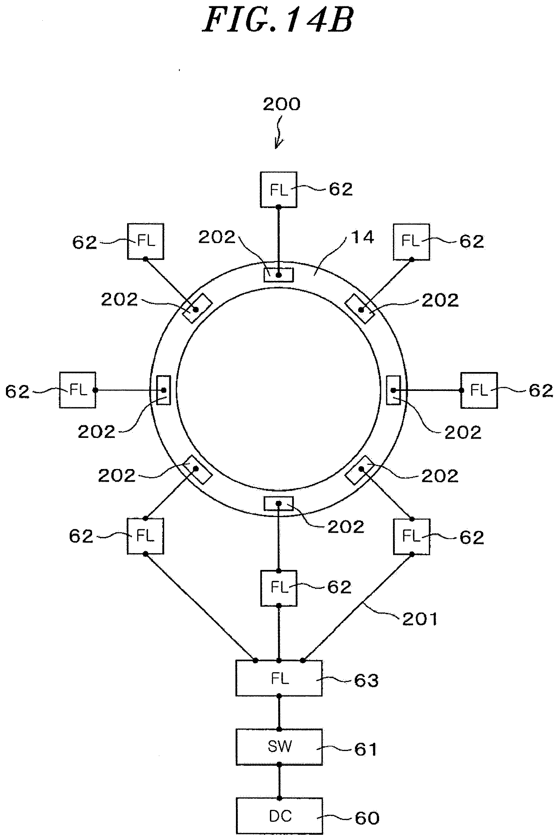

As shown in FIG. 14B, for example, a plurality (e.g., eight) of first RF filters 62 and one second RF filter 63 may be provided for eight conductor members 202. As described above, the number of the first RF filters 62 can be appropriately set with respect to the number of the conductor members 202. Further, the relay member 270 may also be provided in the example of FIG. 14B.

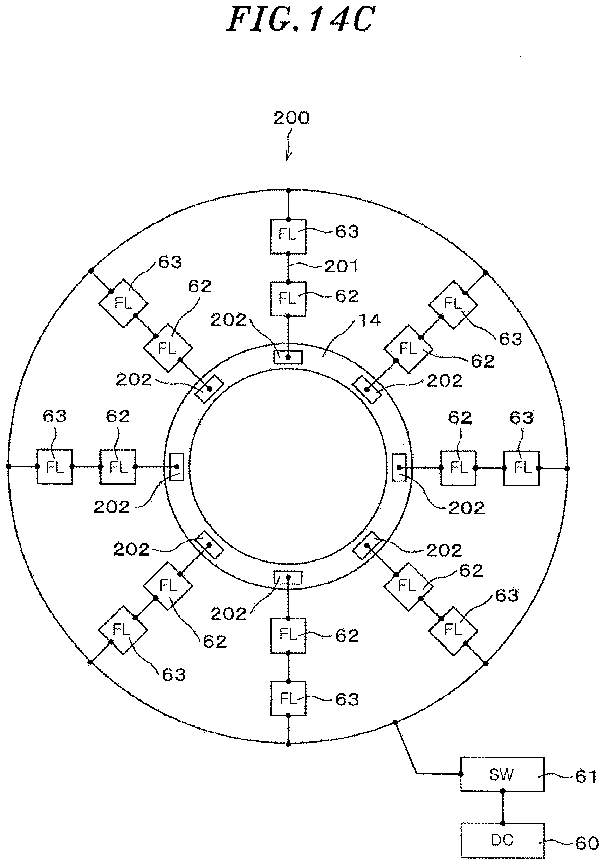

As shown in FIG. 14C, for example, a plurality (e.g., eight) of first RF filters 62 and a plurality (e.g., eight) of second RF filters 63 may be provided for the eight conductor members 202. As described above, the number of the second RF filters 63 whose impedance is variable can be appropriately set with respect to the number of the conductor members 202. Further, the relay member 270 may also be provided in the example of FIG. 14C.

By providing the plurality of second RF filters 63 having variable impedances, it is possible to individually and independently control the electrical characteristics of the plurality of conductor members 202. As a result, the electrical characteristics for each of the plurality of conductor members 202 can be made uniform, and the uniformity of the process can be improved.

### <Alternative Embodiment>

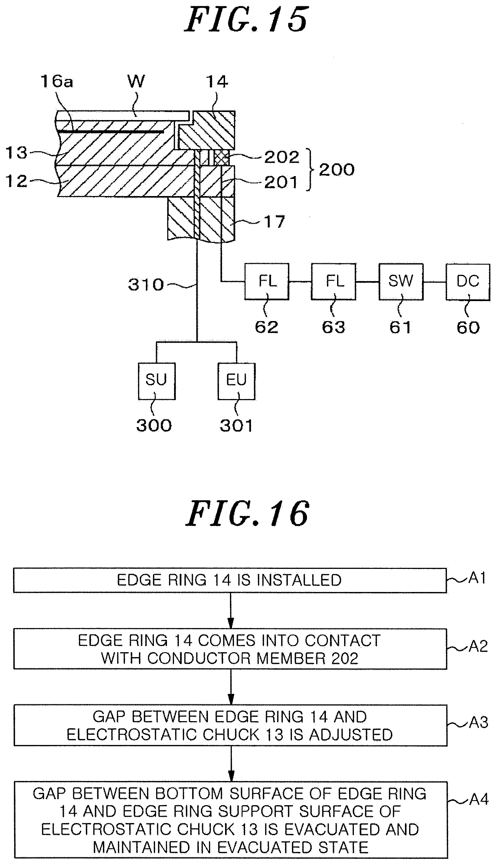

Hereinafter, a sequence of electrostatically attracting and holding the edge ring 14 onto the electrostatic chuck 13 will be described. In this sequence, as shown in FIG. 15, a supply unit (SU) 300 and an exhaust unit (EU) 301 provided in the etching apparatus 1 are used. The supply unit 300 is configured to supply a gas, for example, a helium gas, to a gap between the bottom surface of the edge ring 14 and the edge ring support surface of the electrostatic chuck 13 through a pipe 310. The exhaust unit 301 is configured to evacuate the gap between the bottom surface of the edge ring 14 and the edge ring support surface of the electrostatic chuck 13 through the pipe 310. The pipe 310 is provided with a pressure sensor (not shown) for measuring the pressure inside the pipe 310. In the illustrated example, the connecting unit 200 includes the conductor member 202, but the connecting unit 200 may have one of the other contact structures described above.

The electrostatic adsorption sequence of the edge ring 14 with respect to the electrostatic chuck 13 is classified into a temporary adsorption sequence and a main adsorption sequence. Specifically, in the temporary adsorption, the edge ring 14 is positioned and held on the electrostatic chuck 13. Thereafter, in the main adsorption, the edge ring 14 is electrostatically attracted to and held on the electrostatic chuck 13 and the wafer W is in an etchable state (idling state). The temporary adsorption and the main adsorption may be performed consecutively or intermittently.

### <Temporary adsorption sequence>

FIG. 16 shows an example of a flow of the temporary adsorption sequence of the edge ring 14. The temporary adsorption of the edge ring 14 is performed in a state where the inside of the chamber 10 is open to the atmosphere.

First, the edge ring 14 is installed on the top surface of the electrostatic chuck 13 (step A1 in FIG. 16). Then, the bottom surface of the edge ring 14 and the conductor member 202 come into contact with each other (step A2 in FIG. 16). In step A2, since the edge ring 14 is not attracted to and held on the electrostatic chuck 13 and receives the elastic force (reaction force) of the conductor member 202, the edge ring 14 is positioned higher than a predetermined installation position.

Next, a gap between the edge ring 14 and the electrostatic chuck 13 is adjusted (step A3 in FIG. 16). Here, when the edge ring 14 is installed in step A1, if air is present between the edge ring 14 and the electrostatic chuck 13, the edge ring 14 is installed after being slid sideways. Therefore, in step A3, the gap between the edge ring 14 and the electrostatic chuck 13 is adjusted such that the gap is uniform in the circumferential direction. Further, at this time, the edge ring 14 is positioned higher than the predetermined installation position by the elastic force of the conductor member 202 and the contact area with the electrostatic chuck 13 is minimized. Since the edge ring 14 is slightly separated from the electrostatic chuck 13, it is easy to adjust the gap. Moreover, since the contact area is minimized, it is possible to suppress the generation of dust due to the contact.

Thereafter, the gap between the bottom surface of the edge ring 14 and the edge ring support surface of the electrostatic chuck 13 is evacuated and maintained in the evacuated state by the exhaust unit 301 (step A4 in FIG. 16). In the temporary adsorption, the edge ring 14 is not electrostatically attracted and held. In such a manner, the edge ring 14 is positioned and held.

### <Main adsorption sequence>

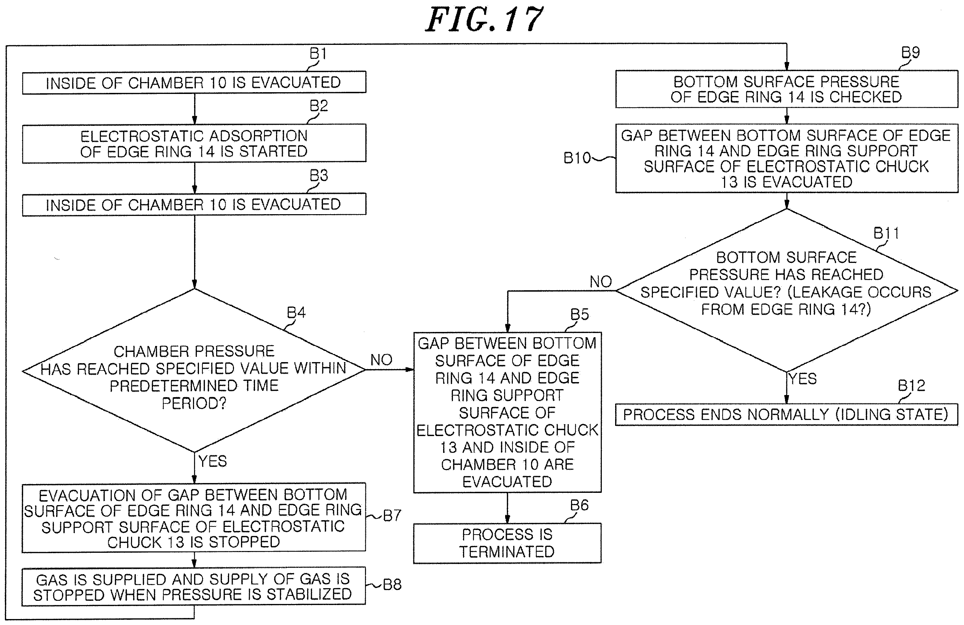

FIG. 17 shows an example of a flow of the main adsorption sequence of the edge ring 14. The main adsorption of the edge ring 14 is performed in a state where the pressure in the chamber 10 is reduced to a desired vacuum level after the temporary adsorption is performed.

First, the inside of the chamber 10 is evacuated by the exhaust device 42 (step B1 in FIG. 17). At this time, the gap between the bottom surface of the edge ring 14 and the edge ring support surface of the electrostatic chuck 13 is evacuated by the exhaust unit 301.

Next, a DC voltage is applied to the second electrode 16b to electrostatically attract and hold the edge ring 14 onto the electrostatic chuck 13 (step B2 in FIG. 17). At this time, the exhaust device 42 continuously evacuates the inside of the chamber 10 (step B3 in FIG. 17). Further, the exhaust unit 301 continuously evacuates the gap between the bottom surface of the edge ring 14 and the edge ring support surface of the electrostatic chuck 13.

Next, it is determined whether or not the pressure inside the chamber 10 (hereinafter, referred to as "chamber pressure") has reached a specified value within a predetermined time period (step B4 in FIG. 17). If the chamber pressure does not reach the specified value, the exhaust unit 301 continuously evacuates the gap between the bottom surface of the edge ring 14 and the edge ring support surface of the electrostatic chuck 13 and the exhaust device 42 continuously evacuates the inside of the chamber 10 (step B5 in FIG. 17). Then, the process is terminated (step B6 in FIG. 17).

On the other hand, if the chamber pressure reaches a specified value in step B4, the evacuation of the gap between the bottom surface of the edge ring 14 and the edge ring support surface of the electrostatic chuck 13 by the exhaust unit 301 is stopped (step B7 in FIG. 17). Thereafter, a gas is supplied from the supply unit 300 to the gap between the bottom surface of the edge ring 14 and the edge ring support surface of the electrostatic chuck 13 and the supply of the gas from the supply unit 300 is stopped when the pressure inside the pipe 310 is stabilized (step B8 in FIG. 17).

Next, by using the pressure sensor provided in the pipe 310, the pressure acting on the bottom surface of the edge ring 14 (hereinafter referred to as "bottom surface pressure") is checked (step B9 in FIG. 17). Then, the gap between the bottom surface of the edge ring 14 and the edge ring support surface of the electrostatic chuck 13 is evacuated by the exhaust unit 301 (step B10 in FIG. 17).

Here, if the edge ring 14 is properly attracted and held in a state where the inside of the pipe 310 is filled with a gas, a small amount of gas leaks from the pipe 310. On the other hand, if the edge ring 14 is not properly attracted and held, a large amount of gas leaks from the pipe 310. Therefore, the bottom surface pressure of the edge ring 14 is checked (step B11 in FIG. 17). That is, in step B11, a gas leak from the pipe 310 is checked. Then, if the bottom surface pressure of the edge ring 14 does not reach a specified value, the exhaust unit 301 continuously evacuates the gap between the bottom surface of the edge ring 14 and the edge ring support surface of the electrostatic chuck 13 and the exhaust device 42 continuously evacuates the inside of the chamber 10 (Step B5 in FIG. 17). Then, the process is terminated (step B6 in FIG. 17) .

On the other hand, if the bottom surface pressure of the edge ring 14 reaches the specified value, the process ends normally (step B12 in FIG. 17). Then, the wafer W is maintained in an etchable state (idling state). In this idling state, the gap between the bottom surface of the edge ring 14 and the edge ring support surface of the electrostatic chuck 13 is continuously evacuated by the exhaust unit 301 and the edge ring 14 is continuously electrostatically attracted and held by the second electrode 16b.

When the edge ring 14 is actually attracted and held as described in this embodiment, an electrostatic force acts between the edge ring 14 and the electrostatic chuck 13. Then, by adjusting the balance between the weight of the edge ring 14, the elastic force of the conductor member 202, and the electrostatic force acting on the edge ring 14, the conductor member 202 comes into close contact with the conductor structure 201 and the bottom surface of the edge ring 14 at a desired contact pressure.

Meanwhile, the edge ring 14 may be replaced automatically by using a transfer device (not shown) provided outside the etching apparatus 1. The replacement of the edge ring 14 can be performed without opening the inside of the chamber 10 to the atmosphere. Then, when the edge ring 14 is replaced, the temporary adsorption sequence and the main adsorption sequence of the present embodiment can be applied, and the same effect as that of the present embodiment can be obtained.

### <Alternative Embodiment>

In the above-described embodiments, the DC voltage from the DC power supply 60 and the impedance of the second RF filter 63 are individually adjusted. However, the DC voltage and the impedance may be simultaneously adjusted.

### <Alternative Embodiment>

In the above-described embodiments, both the DC voltage from the DC power supply 60 and the impedance of the second RF filter 63 are adjusted. However, the tilting angle may be controlled by adjusting only the DC voltage or by adjusting only the impedance.

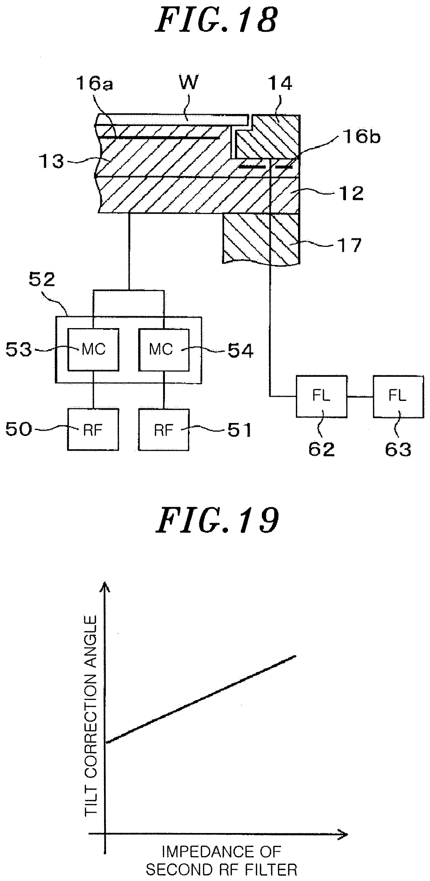

For example, as shown in FIG. 18, the DC power supply 60 and the switching unit 61 may not be connected to the edge ring 14. Even in such a case, the tilting angle can be controlled only by adjusting the impedance of the second RF filter 63 as shown in FIG. 19. The vertical axis of FIG. 19 indicates the tilt correction angle and the horizontal axis indicates the impedance. In the example shown in FIG. 19, the impedance and the tilt correction angle have a linear relationship. Further, in the example shown in FIG. 19, the tilt correction angle is increased by increasing the impedance. However, depending on the configuration of the second RF filter 63, it is possible to decrease the tilt correction angle by increasing the impedance. The relationship between the impedance and the tilt correction angle is not limited since it depends on the design of the second RF filter 63.

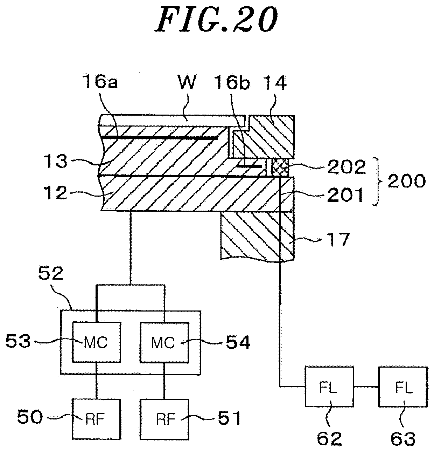

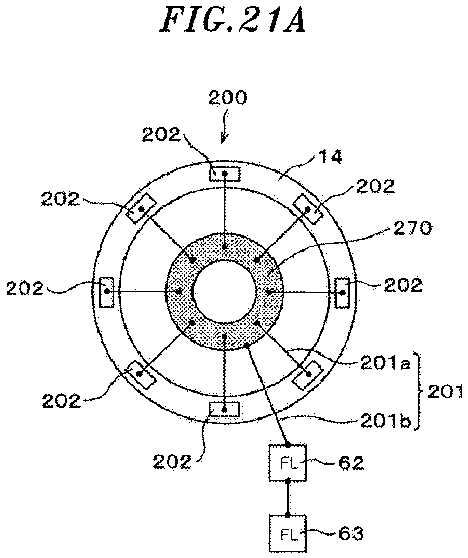

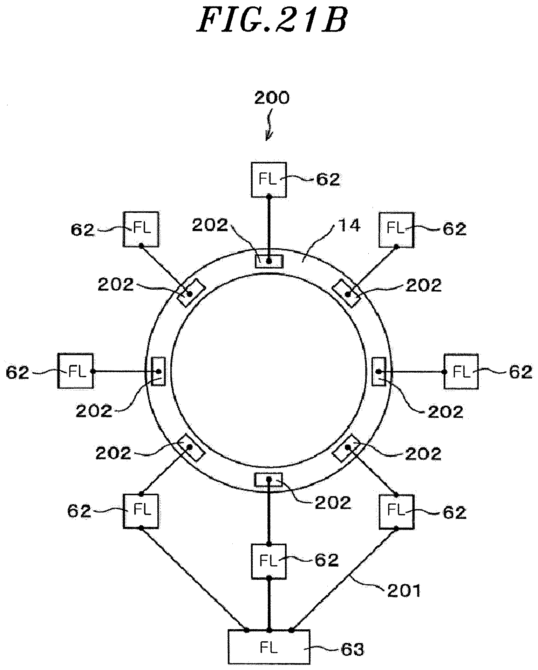

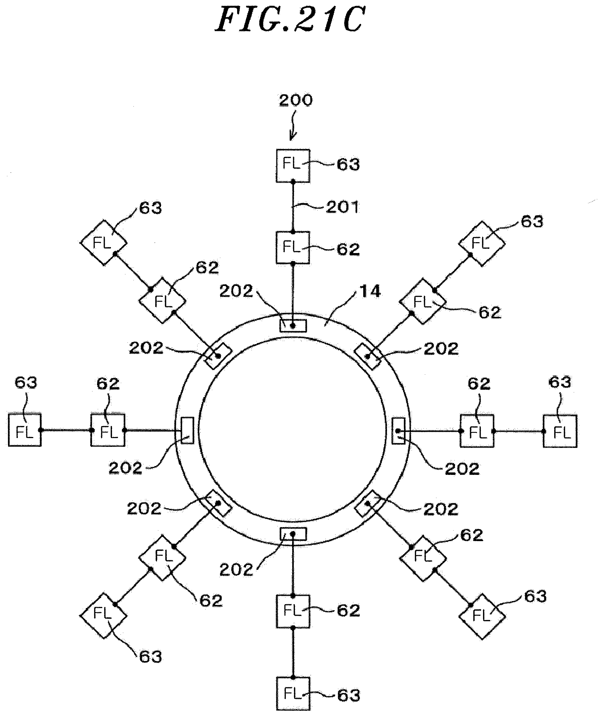

Further, even when the DC power supply 60 and the switching unit 61 are not connected to the edge ring 14 as in the present embodiment, the edge ring 14 and the second RF filter 63 may be directly connected through the connecting unit as in the previously described embodiment. For example, as shown in FIG. 20, the edge ring 14 and the second RF filter 63 may be electrically directly connected through the connecting unit 200. The configuration and arrangement of the connecting unit 200 may be the same as those shown in the examples of FIGS. 11A to 11F and FIGS. 12A to 12C, for example. Alternatively, the contact structure for contacting the edge ring 14 is not limited thereto and may be the same as those shown in the examples of FIGS. 13A to 13G. Further, as shown in FIGS. 21A to 21C, the configurations of the connecting unit 200, the first RF filter 62, and the second RF filter 63 may be the same as those shown in the examples of FIGS. 14A to 14C except that the DC power supply 60 and the switching unit 61 are not connected to the edge ring 14.

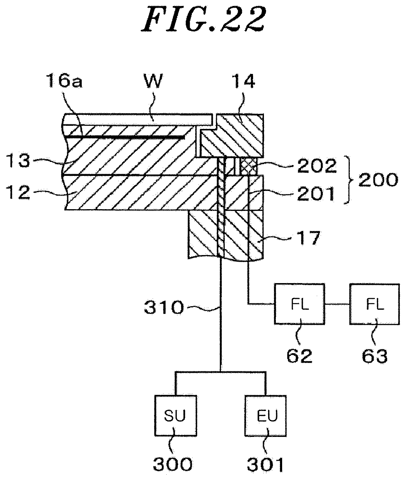

Further, when the DC power supply 60 and the switching unit 61 are not connected to the edge ring 14 as in the present embodiment, the sequence of electrostatically attracting and holding the edge ring 14 onto the electrostatic chuck 13 is the same as that of the previously described embodiment. That is, in this sequence, a supply unit 300 and an exhaust unit 301 provided in the etching apparatus 1 as shown in FIG. 22 are used. The configurations of the supply unit 300 and the exhaust unit 301 are the same as those shown in the example of FIG. 15. Then, the temporary adsorption sequence shown in FIG. 16 and the main adsorption sequence shown in FIG. 17 are performed.

### <Alternative Embodiment>

In the above-described embodiments, the DC power supply 60 is connected to the edge ring 14 through the switching unit 61, the first RF filter 62, and the second RF filter 63. However, a power supply system that applies a DC voltage to the edge ring 14 is not limited thereto. For example, the DC power supply 60 may be electrically connected to the edge ring 14 through the switching unit 61, the second RF filter 63, the first RF filter 62, and the lower electrode 12. In such a case, the lower electrode 12 and the edge ring 14 are directly electrically coupled, and the self-bias voltage of the edge ring 14 becomes the same as the self-bias voltage of the lower electrode 12.

Here, in the case where the lower electrode 12 and the edge ring 14 are directly electrically coupled, the sheath thickness above the edge ring 14 cannot be adjusted due to, for example, the capacitance determined by a hardware structure below the edge ring 14 and an outer tilt state may occur even though no DC voltage is applied. In the present disclosure, the tilting angle is controlled by adjusting the DC voltage from the DC power supply 60 and the impedance of the second RF filter 63. Therefore, the tilting angle can be changed toward the inner side and adjusted to 0 (zero) degrees.

### <Alternative Embodiment>

In the above-described embodiments, the DC voltage from the DC power supply 60 or the impedance of the second RF filter 63 is adjusted according to the consumption amount of the edge ring 14. However, the DC voltage adjustment timing or the impedance adjustment timing is not limited thereto. For example, the DC voltage or the impedance may be adjusted according to the processing time of the wafer W. Alternatively, for example, the processing time of the wafer W and a predetermined parameter such as RF power may be combined to determine the adjustment timing of the DC voltage or the impedance.

### <Alternative Embodiment>

In the above-described embodiments, the impedance of the second RF filter 63 is variable. However, the impedance of the first RF filter 62 may be variable or the impedances of both of the first and second RF filters 62 and 63 may be variable. Further, in the above-described embodiments, two RF filters 62 and 63 are provided for the DC power supply 60. However, the number of RF filters is not limited thereto and may be one, for example. Further, in the above-described embodiments, the impedance is variable by providing some of the elements of the second RF filter 63 as variable elements. However, the configuration in which the impedance is variable is not limited thereto. For example, a device capable of varying an impedance of a RF filter may be connected to the RF filter having a variable impedance or a fixed impedance. That is, a RF filter having a variable impedance may be composed of an RF filter and the device that is connected to the corresponding RF filter to vary the impedance of the corresponding RF filter.

### <Alternative Embodiment>

In the above-described embodiments, the etching apparatus 1 is the capacitively-coupled etching apparatus. However, the etching apparatus to which the embodiments of the present disclosure are employed is not limited thereto. For example, the etching apparatus may be an inductively-coupled etching apparatus.

Further, the presently disclosed embodiment further includes the following aspects of Appendices 1 to 21.

### (Appendix 1)

An apparatus for etching a substrate includes:
a chamber;
a substrate support disposed in the chamber, the substrate support having an electrode, an electrostatic chuck disposed on the electrode, and an edge ring disposed to surround the substrate placed on the electrostatic chuck;
a radio frequency (RF) power supply configured to supply RF power to generate plasma from a gas inside the chamber;
a DC power supply configured to apply a negative DC voltage to the edge ring;
a RF filter whose impedance is variable; and
a controller configured to control the DC voltage and the impedance to adjust a tilting angle in an edge region of the substrate placed on the electrostatic chuck.

### (Appendix 2)

In the apparatus of Appendix 1, the controller controls the apparatus to execute processes of:
(a) adjusting the DC voltage, and
(b) adjusting the impedance after an absolute value of the DC voltage adjusted in the process (a) reaches a predetermined value.

### (Appendix 3)

In the apparatus of Appendix 2, the predetermined value in the process (b) is an upper limit of the absolute value of the DC voltage.

### (Appendix 4)

In the apparatus of Appendix 2 or 3, the controller adjusts the DC voltage in the process (a) to correct the tilting angle and adjusts the impedance in the process (b) to reduce the absolute value of the DC voltage while maintaining the tilting angle.

### (Appendix 5)

In the apparatus of Appendix 2 or 3, the controller adjusts the DC voltage in the process (a) to correct the tilting angle and adjusts the impedance in the process (b) to correct the tilting angle.

### (Appendix 6)

In the apparatus of any one of Appendices 2 to 5, the controller adjusts the DC voltage in the process (a) according to a consumption amount of the edge ring.

### (Appendix 7)

In the apparatus of Appendix 1, the controller controls the apparatus to execute processes of:
(c) adjusting the impedance, and
(d) adjusting the DC voltage after the impedance adjusted in the process (c) reaches a predetermined value.

### (Appendix 8)

In the apparatus of Appendix 7, the predetermined value in the process (d) is an upper limit of the impedance.

### (Appendix 9)

In the apparatus of Appendix 7 or 8, the controller adjusts the impedance in the process (c) to correct the tilting angle and adjusts the DC voltage in the process (d) to correct the tilting angle.

### (Appendix 10)

In the apparatus of any one of Appendices 7 to 9, the controller adjusts the impedance in the process (c) according to a consumption amount of the edge ring.

### (Appendix 11)

In the apparatus of Appendix 6 or 10, the controller calculates the consumption amount of the edge ring based on an etching time of the substrate.

### (Appendix 12)

The apparatus of Appendix 6 or 10 further includes a measuring device configured to measure a thickness of the edge ring.

Further, the controller controls the measuring device to calculate a difference between an initial thickness of the edge ring measured in advance and a thickness of the edge ring after etching to determine the consumption amount of the edge ring.

### (Appendix 13)

The apparatus of Appendix 6 or 10 further includes a measuring device configured to measure electrical characteristics of the edge ring or around the edge ring.

Further, the controller controls the measuring device to calculate the consumption amount of the edge ring based on a change in the electrical characteristics.

### (Appendix 14)

In the apparatus of any one of Appendices 1 to 13, the DC power supply is connected to the edge ring through the RF filter.

### (Appendix 15)

In the apparatus of any one of Appendices 1 to 13, the DC power supply is connected to the edge ring through the RF filter and the electrode.

### (Appendix 16)

In the apparatus of any one of Appendices 1 to 15, the RF filter whose impedance is variable includes a first RF filter and a second RF filter.

### (Appendix 17)

In the apparatus of Appendix 16, at least one of the first RF filter and the second RF filter has a variable impedance.

### (Appendix 18)

In the apparatus of any one of Appendices 1 to 17, the RF filter includes one or more variable elements, each of which is capable of varying the impedance.

### (Appendix 19)

In the apparatus of any one of Appendices 1 to 18, the RF filter includes a plurality of elements and a switching circuit configured to vary the impedance by changing a combination of the plurality of elements.

### (Appendix 20)

In the apparatus of any one of Appendices 1 to 19, the RF filter whose impedance is variable includes an RF filter having a variable impedance or a fixed impedance and a device that is connected to the corresponding RF filter and is configured to vary the impedance of the corresponding RF filter.

### (Appendix 21)

A method of etching a substrate using an etching apparatus including a chamber; a substrate support disposed in the chamber, the substrate support having an electrode, an electrostatic chuck disposed on the electrode, and an edge ring disposed to surround the substrate placed on the electrostatic chuck; a radio frequency (RF) power supply configured to supply RF power to generate plasma from a gas inside the chamber; a DC power supply configured to apply a negative DC voltage to the edge ring; and a RF filter whose impedance is variable,
the method comprising:
controlling the DC voltage and the impedance; and
adjusting a tilting angle in an edge region of the substrate placed on the electrostatic chuck.

The presently disclosed embodiments are considered in all respects to be illustrative and are not restrictive. The above-described embodiments can be embodied in various forms. Further, the above-described embodiments may be omitted, replaced, or changed in various forms without departing from the scope of the appended claims and the gist thereof.

## Claims

1. An apparatus for etching a substrate, comprising:
a chamber;
a substrate support disposed in the chamber, the substrate support having an electrode, an electrostatic chuck disposed on the electrode, and a conductive edge ring disposed to surround the substrate placed on the electrostatic chuck;
a radio frequency (RF) power supply configured to supply RF power to generate plasma from a gas inside the chamber; and
a RF filter whose impedance is variable,
wherein the edge ring and the RF filter are electrically directly connected through a connecting unit.

2. The apparatus of claim 1, further comprising:
a controller,
wherein the controller is configured to execute a process of changing a voltage generated in the edge ring by varying the impedance.

3. The apparatus of claim 1 or 2, further comprising:
an additional RF power supply configured to supply RF bias power for drawing ions into the substrate,
wherein a frequency of the RF bias power is in a range from 5 MHz or less.

4. The apparatus of any one of claims 1 to 3, wherein the connecting unit includes a conductor structure that connects the edge ring and the RF filter.

5. The apparatus of claim 4, wherein the connecting unit further includes a conductor member provided between the edge ring and the conductor structure.

6. The apparatus of claim 5, wherein the conductor member is an elastic body and a contact pressure acting between the edge ring and the conductor structure is adjusted by an elastic force of the conductor member.

7. The apparatus of claim 5 or 6, wherein the connecting unit includes a plurality of conductor members, each of which corresponds to the conductor member of claim 5, and
the conductor members are disposed at equal intervals on a concentric circle with the edge ring.

8. The apparatus of claim 5 or 6, wherein the conductor member has an annular shape and is disposed concentrically with the edge ring.

9. The apparatus of claim 4, wherein the connecting unit further includes a clamp member that fittedly encloses the edge ring therein on a side of the conductor structure and connects the edge ring and the conductor structure.

10. The apparatus of any one of claims 4 to 9, wherein the connecting unit further includes a relay member that has an annular shape and is disposed concentrically with the edge ring in the conductor structure.

11. The apparatus of any one of claims 4 to 10, wherein the edge ring is attracted to and held on a peripheral portion of the electrostatic chuck by an electrostatic force, and a contact pressure acting between the edge ring and the conductor structure is adjusted by the electrostatic force.

12. The apparatus of claim 11, further comprising:
a supply unit configured to supply a gas to a gap between a bottom surface of the edge ring and an edge ring support surface of the electrostatic chuck;
an exhaust unit configured to evacuate the gap between the bottom surface of the edge ring and the edge ring support surface of the electrostatic chuck; and
a controller,
wherein the controller controls the supply unit and the exhaust unit, so that a desired pressure acts on the bottom surface of the edge ring when the edge ring is attracted to and held on the electrostatic chuck.

13. The apparatus of any one of claims 1 to 12, wherein the RF filter whose impedance is variable includes a first RF filter and a second RF filter.

14. The apparatus of any one of claims 1 to 13, wherein the conductive edge ring is made of Si or SiC.

15. The apparatus of any one of claims 1 to 14, wherein the RF filter includes one or more variable elements, each of which is capable of varying the impedance.

16. The apparatus of any one of claims 1 to 15, wherein the RF filter includes a plurality of elements and a switching circuit configured to vary the impedance by changing a combination of the plurality of elements.

17. A method of etching a substrate using an etching apparatus including a chamber; a substrate support disposed in the chamber, the substrate support having an electrode, an electrostatic chuck disposed on the electrode, and a conductive edge ring disposed to surround the substrate placed on the electrostatic chuck; a radio frequency (RF) power supply configured to supply RF power to generate plasma from a gas inside the chamber; and a RF filter whose impedance is variable, the edge ring and the RF filter being electrically directly connected through a connecting unit,
the method comprising:
changing a voltage generated in the edge ring by varying the impedance; and
correcting a tilting angle in an edge region of the substrate placed on the electrostatic chuck to a desired value.
